# EUROPEAN PATENT APPLICATION

(11) **EP 4 503 431 A1**
(43) Date of publication of application: **05.02.2025**
(21) Application number: 23775029.4
(22) Date of filing: 23.03.2023
(51) Int. Cl.: H02S 20/23, E04D 13/18, H02S 20/26, H02S 30/00

(54) **SOLAR CELL SHEET INSTALLATION STRUCTURE, SOLAR CELL SHEET CONSTRUCTION METHOD, AND SOLAR CELL SHEET FOR TEXTURED EXTERIOR MATERIAL**

(30) Priority: 24.03.2022 JP 2022048063
(71) Applicant: SEKISUI CHEMICAL CO., LTD., Osaka-shi Osaka 530-8565 (JP)
(72) Inventor: YOKOTA, Ibuki, Osaka-shi, Osaka 530-8565 (JP); MATSUSHIMA, Kazushi, Osaka-shi, Osaka 530-8565 (JP)
(74) Representative: Ter Meer Steinmeister & Partner
(86) International application number: PCT/JP2023/011544
(87) International publication number: WO 2023/182435

(57) **Abstract**

To widen an area of a power generator as much as possible. An installation structure 100 for a photovoltaic power generation sheet includes an exterior member 3 in which a plurality of convex portions 32 extending in one direction are formed at intervals in a direction orthogonal to the one direction, a photovoltaic power generation sheet 1 being flexible and disposed across the plurality of convex portions 32, and a fixing member 5 that fixes the photovoltaic power generation sheet 1 to a portion between adjacent convex portions 32 in a state where the photovoltaic power generation sheet 1 is curved along the plurality of convex portions 32 in a cross section.

## Description

### Technical Field

The present disclosure relates to an installation structure for a photovoltaic power generation sheet, a method for constructing a photovoltaic power generation sheet, and a photovoltaic power generation sheet for an uneven exterior member.

### Background Art

PTL 1 discloses an installation structure of a solar cell panel. In the installation structure of the solar cell panel described in PTL 1, the solar cell panel is placed on a plurality of crest portions of a folded plate roof and fixed to an upper surface of the crest portions by a support fitting.

### Citation List

### Patent Literature

PTL 1: Japanese Utility Model Registration No. 3228655

### Summary of Invention

### Technical Problem

In the solar panel described in PTL 1, in order to improve power generation efficiency, it is conceivable to increase the area of the power generator by increasing the entire area of the solar panel. However, there are restrictions on the installation space of the roof surface, and it may not be possible to install the solar cell panel simply by expanding the area of the solar cell panel.

An object of the present disclosure is to provide an installation structure for a photovoltaic power generation sheet, a method for constructing a photovoltaic power generation sheet, and a photovoltaic power generation sheet for an uneven exterior member, wherein, the solar power generation sheet can increase a surface area of a solar cell panel per unit area of a roof surface in plan view as much as possible.

### Solution to Problem

In order to achieve the above object, the present disclosure encompasses the subject matter according to the following items.

Item 1. An installation structure for a photovoltaic power generation sheet including:
an exterior member in which a plurality of convex portions extending in one direction are formed at intervals in a direction orthogonal to the one direction;
a photovoltaic power generation sheet that is disposed across the plurality of convex portions and is flexible; and
a fixing member that fixes the photovoltaic power generation sheet to a portion between the convex portions adjacent in a state where the photovoltaic power generation sheet is curved along the plurality of convex portions in a cross section.

Item 2. The installation structure according to item 1, wherein the photovoltaic power generation sheet has a flexural strength of 10 MPa or more and 200 MPa or less.

Item 3. The installation structure according to item 1 or 2, wherein the photovoltaic power generation sheet has a flexural modulus of 100 MPa or more and 10,000 MPa or less.

Item 4. The installation structure according to any one of items 1 to 3, wherein a portion of the photovoltaic power generation sheet fixed to the fixing member is positioned closer to a base side of the convex portion than a top surface of the convex portion.

Item 5. The installation structure according to any one of items 1 to 4, wherein the photovoltaic power generation sheet is not fixed to the plurality of convex portions.

Item 6. The installation structure according to any one of items 1 to 5, wherein the photovoltaic power generation sheet includes a power generator containing a perovskite compound.

Item 7. The installation structure according to any one of items 1 to 6, wherein the fixing member is attached to a portion other than the power generator in the photovoltaic power generation sheet.

Item 8. The installation structure according to item 7, wherein a minimum distance between the fixing member and the power generator positioned closest to the fixing member is 1.5 cm or more.

Item 9. The installation structure according to any one of items 1 to 8, wherein
the exterior member is a roof member,
the photovoltaic power generation sheet includes one barrier sheet covering a plurality of power generators, and
an intermediate portion of the one barrier sheet is fixed by the fixing member with respect to a portion between the convex portions adjacent, so that the intermediate portion constitutes a drain portion that is recessed and inclined downward the water down side.

Item 10. A method for constructing a photovoltaic power generation sheet for attaching the photovoltaic power generation sheet being flexible to an exterior member where a plurality of convex portions extending in one direction is formed at intervals in a direction orthogonal to the one direction, the method including:
fixing the photovoltaic power generation sheet to a portion between the plurality of convex portions in a state where the photovoltaic power generation sheet is curved along the plurality of convex portions in a cross section.

Item 11. A photovoltaic power generation sheet for an uneven exterior member, the photovoltaic power generation sheet being attached to an exterior member in which a plurality of convex portions extending in one direction is formed at intervals in a direction orthogonal to the one direction in a state where the photovoltaic power generation sheet is curved along the plurality of convex portions in a cross section, the photovoltaic power generation sheet including:
a plurality of power generators; and
an attachment portion provided between the plurality of power generators and fixed to a portion between the convex portions adjacent of the exterior member, wherein
the photovoltaic power generation sheet is flexible.

### Advantageous Effects of Invention

The installation structure for the photovoltaic power generation sheet, the method for constructing the photovoltaic power generation sheet, and the photovoltaic power generation sheet according to one aspect of the present disclosure have an advantage that the surface area of the solar cell panel per unit area of the roof surface can be increased as much as possible.

### Brief Description of Drawings

Fig. 1 is a perspective view of a state in which a photovoltaic power generation sheet is removed in an installation structure for a photovoltaic power generation sheet according to a first embodiment of the present disclosure.
Fig. 2 is a longitudinal sectional view of the installation structure according to the first embodiment.
Fig. 3(A) is a cross-sectional view of the photovoltaic power generation sheet according to the first embodiment. Fig. 3(B) is an enlarged view of a part B in Fig. 3(A) . Fig. 3(C) is a cross-sectional view taken along line A-A of Fig. 3(A).
Fig. 4 is a perspective view illustrating a relationship between a fixing member and a power generator in an installation structure for a photovoltaic power generation sheet according to the first embodiment.
Fig. 5 is a front view of an installation structure for a photovoltaic power generation sheet according to a first modification.
Fig. 6 is a cross-sectional view of an installation structure for a photovoltaic power generation sheet according to a second modification.
Fig. 7 is a cross-sectional view of an installation structure for a photovoltaic power generation sheet according to a third modification.
Fig. 8 is a cross-sectional view of an installation structure for a photovoltaic power generation sheet according to a fourth modification.
Fig. 9 is a cross-sectional view of an installation structure for a photovoltaic power generation sheet according to a fifth modification.
Fig. 10 is a plan view of a photovoltaic power generation sheet according to a sixth modification.
Fig. 11(A) is a plan view of a spacer member according to a sixth modification. Fig. 11(B) is a front view of a spacer member according to a sixth modification. Fig. 11(C) is a cross-sectional view taken along line B-B of Fig. 11(A) .
Fig. 12(A) is a plan view of a photovoltaic power generation sheet according to a seventh modification. Fig. 12(B) is a cross-sectional view taken along line C-C of Fig. 12(A) .
Fig. 13(A) is a plan view of a photovoltaic power generation sheet according to an eighth modification. Fig. 13(B) is a cross-sectional view taken along line D-D of Fig. 13(A) .
Fig. 14 is a plan view of a photovoltaic power generation sheet according to a ninth modification.
Fig. 15(A) is a plan view of a photovoltaic power generation sheet according to a tenth modification. Fig. 15(B) is a cross-sectional view taken along line E-E of Fig. 15(A) .
Fig. 16(A) is a plan view of a photovoltaic power generation sheet according to an eleventh modification. Fig. 10(B) is a cross-sectional view taken along line F-F in Fig. 10(A) .
Figs. 17(A) to 17(C) are longitudinal sectional views of a spacer member according to a twelfth modification.
Fig. 18 is an exploded perspective view of an installation structure for a photovoltaic power generation sheet according to a second embodiment.
Fig. 19 is a cross-sectional view of an installation structure for a photovoltaic power generation sheet according to the second embodiment taken along a cross section orthogonal to a water flow direction.
Fig. 20 is a plan view of an installation structure for a photovoltaic power generation sheet according to the second embodiment.
Fig. 21 is a plan view of an installation structure for a photovoltaic power generation sheet according to a sixteenth modification.
Fig. 22 is a plan view of an installation structure for a photovoltaic power generation sheet according to an additional modification of the sixteenth modification.
Fig. 23 is an exploded perspective view of an installation structure for a photovoltaic power generation sheet according to a third embodiment.
Fig. 24 is a plan view of an installation structure for a photovoltaic power generation sheet according to the third embodiment.
Fig. 25 is a plan view of an installation structure for a photovoltaic power generation sheet according to a seventeenth modification.
Fig. 26 is a plan view of an installation structure for a photovoltaic power generation sheet according to an eighteenth modification.
Fig. 27 is a plan view of an installation structure for a photovoltaic power generation sheet according to a nineteenth modification.

### Description of Embodiments

### First embodiment

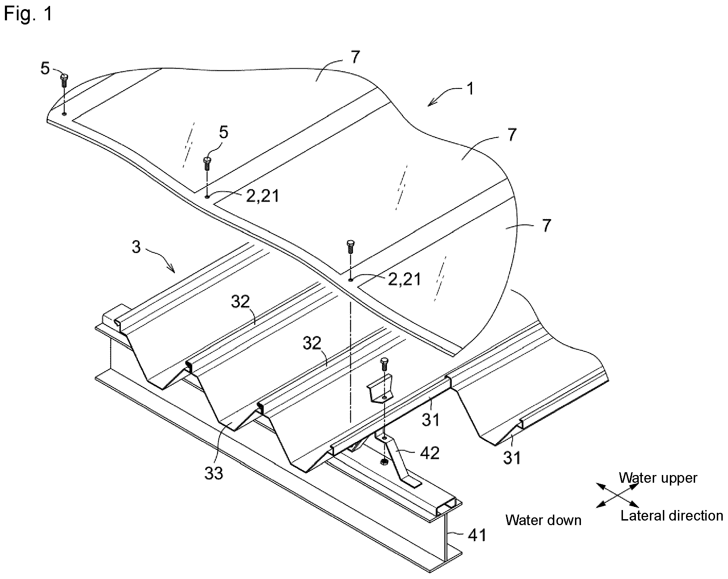

An installation structure 100 (hereinafter, simply referred to as an "installation structure 100") for a photovoltaic power generation sheet 1 according to the present embodiment is a structure in which the photovoltaic power generation sheet 1 is attached to an exterior member 3. As illustrated in Fig. 1, the installation structure 100 includes an exterior member 3, a photovoltaic power generation sheet 1, and a plurality of fixing members 5.

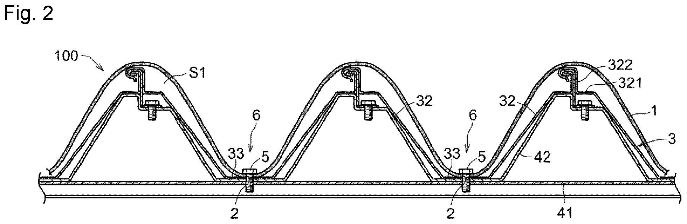

In the exterior member 3, a plurality of convex portions 32 extending in one direction are formed at intervals. The photovoltaic power generation sheet 1 is flexible. The photovoltaic power generation sheet 1 is disposed across the plurality of convex portions 32. As illustrated in Fig. 2, the photovoltaic power generation sheet 1 is fixed to a portion between adjacent convex portions 32 by a fixing member 5 in a state where the photovoltaic power generation sheet 1 is curved along the plurality of convex portions 32 in the cross section.

As described above, according to the installation structure 100 of the present embodiment, the photovoltaic power generation sheet 1 is along the plurality of convex portions 32 in the cross section, and is fixed to the portion between adjacent convex portions 32 by the fixing member 5. Therefore, the surface area of the photovoltaic power generation sheet 1 per unit area of the roof surface can be made as large as possible as compared with a flat plate-shaped solar cell panel having high rigidity.

In order to maintain the shape of the photovoltaic power generation sheet 1 that is flexible, it is necessary to relatively increase the number of the fixing members 5 as compared with the solar cell panel. In general, when the number of the fixing members 5 increases, the shadow of the fixing member 5 overlaps the power generator 7, and there is a concern that the power generation efficiency decreases. However, in the present embodiment, by disposing the fixing member 5 in the portion between adjacent convex portions 32, it is possible to prevent the protruding portion in the photovoltaic power generation sheet 1 from overlapping the shadow of the fixing member 5.

Hereinafter, each configuration of the installation structure 100 according to the present embodiment will be described in more detail.

### Exterior member 3

The exterior member 3 is a building material that forms an outer surface of a building. As described above, in the exterior member 3, the plurality of convex portions 32 extending in one direction is formed at intervals in the direction orthogonal to the one direction. Examples of the exterior member 3 include a roof member, a wall member (metal-based siding member, ceramic-based siding member, sandwich panel, and the like), a partition, a door member, and a fence member. The installation object may be a structure such as an automobile, a train, or a ship. In the present embodiment, a roof of a building is an installation object. The building may be a non-residential building or a residential building. The non-residential building is not particularly limited, and examples thereof include a store, a warehouse, a factory, a vinyl house, a greenhouse, a meeting place, a gymnasium, and a parking lot. Examples of the residential building include a wooden house, a steel frame house, a reinforced concrete house, and an aluminum house. In the present embodiment, a roof member of a building will be described as an example of the exterior member 3.

Examples of the roof member include a uneven roof member (uneven exterior member) used for a folded plate roof, a slate roof, a roof deck, a shingled bar-laid roof, an upright flat laid roof, and the like. The roof may be a vertical roof or a horizontal roof. In the present embodiment, as an example of a roof formed by the exterior member 3, a folded plate roof as a vertical roof will be described.

Here, as illustrated in Fig. 1, the highest portion on one roof surface is defined as "water upper", and the lowest portion is defined as "water down". In addition, a direction parallel to a line segment connecting water upper and water down at the shortest distance is defined as a "water flow direction". In the present embodiment, the water upper is the ridge, the water down is the eaves, and the water flow direction is parallel to the eaves ridge direction. In addition, a direction orthogonal to the water flow direction and along the roof surface is defined as a "lateral direction".

As illustrated in Fig. 1, the exterior member 3 is attached to a cross member 41 via a plurality of tight frames 42. The cross member 41 is a horizontal member in a building, and is bridged between columns, for example. Examples of the cross member 41 include a beam (including girders, joists, and the like.), a beam, a purlin, and the like. The tight frames 42 are fixed to the upper surface of the cross member 41 and support the exterior member 3. The plurality of tight frames 42 are arranged at intervals in the water flow direction.

As illustrated in Fig. 1, the exterior member 3 includes a plurality of fold plate members 31. Each of the fold plate members 31 is formed in a substantially V-shaped cross section. Each of the fold plate members 31 is formed by bending a metal plate. The exterior member 3 is disposed in such a manner that the longitudinal direction of each of the plurality of fold plate members 31 is parallel to the water flow direction, and is configured by joining the end portions of adjacent fold plate members 31 to each other. A method for joining adjacent fold plate members 31 is not particularly limited, and examples thereof include a fastening method, a stacking method, and a fitting method. In the present embodiment, as illustrated in Fig. 2, a haze-fastening method is adopted. Hereinafter, the haze-fastened portion may be referred to as a "fastened portion 322".

As illustrated in Fig. 1, the convex portion 32 of the exterior member 3 extends in the water flow direction. The convex portion 32 according to the present embodiment is formed by joining end portions of adjacent fold plate members 31 to each other. A plurality of convex portions 32 are formed in the exterior member 3, and a plurality of convex portions 32 are formed at intervals in the lateral direction. A valley portion 33 is formed between adjacent convex portions 32. In short, in the exterior member 3, the convex portion 32 and the valley portion 33 are repeatedly formed in the lateral direction, and are formed in an uneven cross section.

As illustrated in Fig. 2, each of the convex portions 32 is formed in a shape (an inverted V shape in cross section) in which the width narrows toward a top portion side. The top portion of the convex portions 32 includes a top portion 321 formed in a substantially planar shape and a fastened portion 322 protruding upward from the center of the top portion 321 in the lateral direction. The shape of each of the convex portions 32 does not necessarily have an inverted V-shaped cross section, and may have, for example, a rectangular cross section, a C-shaped cross section, or the like.

In the present embodiment, each of the valley portion 33 is formed in a substantially planar shape Here, in the present disclosure, the valley portion 33 does not need to be a flat surface. For example, in a case where the exterior member 3 is a corrugated slate, the exterior member is formed in a curved surface shape projecting downward. In this case, the boundary between the convex portion 32 and the valley portion 33 does not appear, but a surface passing through the midpoint of the line segment connecting the upper end of the convex portion 32 and the lower end of the valley portion 33 and parallel to the water flow direction is defined as the boundary surface between the convex portion 32 and the valley portion 33.

The height of the convex portion 32 in the cross section of the exterior member 3 is, for example, 1.5 times or more, more specifically, 2 times or more the width of the valley portion 33 in the lateral direction. The upper limit of the height of the convex portion 32 is, for example, 5 times or less the width of the valley portion 33. However, the height of the convex portion 32 is not particularly limited since the height of the convex portion 32 is appropriately set according to the type of the exterior member 3. The "height of the convex portion 32" as used herein refers to a length from the upper surface (upper end) of the valley portion 33 to the upper end of the fastened portion 322 in the end surface orthogonal to the water flow direction of the exterior member 3. The photovoltaic power generation sheet 1 is attached to the surface of the exterior member 3. The surface of the exterior member 3 may be referred to as an installation surface.

### Photovoltaic power generation sheet 1

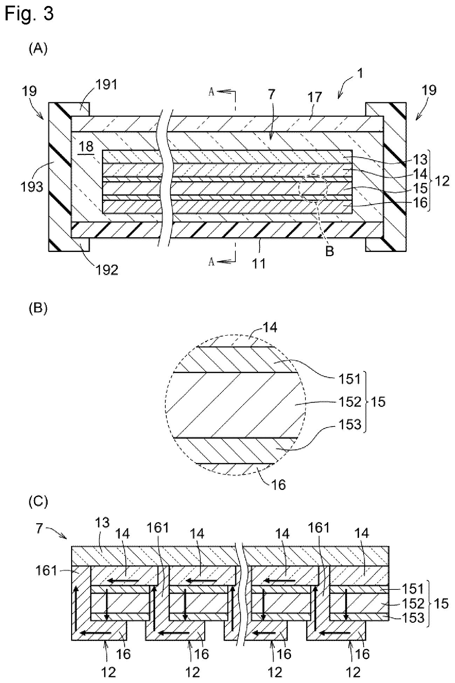

The photovoltaic power generation sheet 1 has a light receiving surface on at least one surface in the thickness direction. The light receiving surface is a surface on which sunlight is incident. As illustrated in Fig. 3, the photovoltaic power generation sheet 1 includes a back sheet 11, a plurality of power generators 7, a barrier sheet 17, a sealing layer 18, and a sealing edge member 19. A plurality of power generators 7 and the sealing layer 18 are disposed between the back sheet 11 and the barrier sheet 17. The sealing edge member 19 seals the outer edge over the entire length in a state where the plurality of power generators 7 and the sealing layer 18 are arranged between the back sheet 11 and the barrier sheet 17.

The photovoltaic power generation sheet 1 is flexible. The term "is flexible" as used herein refers to the property of an object to flex. The flexural strength of the photovoltaic power generation sheet 1 according to the present embodiment is preferably 10 MPa or more, and more preferably 20 MPa or more. The flexural strength of the photovoltaic power generation sheet 1 is preferably 150 MPa or less, and more preferably 50 MPa or less. The flexural modulus of the photovoltaic power generation sheet 1 may be defined as a flexural modulus, and the flexural modulus of the photovoltaic power generation sheet 1 is preferably 100 MPa or more, more preferably 500 MPa or more. On the other hand, the flexural modulus of the photovoltaic power generation sheet 1 is preferably 10,000 MPa or less, and more preferably 5000 MPa or less. In a case where the photovoltaic power generation sheet 1 is defined by the flexural modulus, the flexural strength is not necessarily included in the above range. The flexural strength and flexural modulus of the photovoltaic power generation sheet 1 are measured in accordance with JIS K 7171. By setting the flexural strength of the photovoltaic power generation sheet 1 to 10 MPa or more and 200 MPa or less, it is possible to suppress occurrence of breakage such as cracking while improving construction on the exterior member 3. By setting the flexural modulus of the photovoltaic power generation sheet 1 to 100 MPa or more and 10,000 MPa or less, it is possible to suppress occurrence of breakage such as cracking while improving construction for the exterior member 3. The flexural strength and the flexural modulus of the present description are measured by, for example, a measurement method in accordance with JIS 7171.

The photovoltaic power generation sheet 1 according to the present embodiment is formed in a substantially rectangular shape in plan view. Here, in the present disclosure, the shape of the photovoltaic power generation sheet 1 may be, for example, a substantially circular shape in plan view, an elliptical shape in plan view, a polygonal shape in plan view, or the like, and is not particularly limited.

The term "sheet" or "sheet-like" as used herein refers to a shape in which the thickness of the object is 10% or less with respect to the maximum length between the outer edges in plan view. When the shape in plan view is a rectangular shape, the "maximum length between the outer edges in plan view" refers to a length of a diagonal line. When the shape in plan view is a circular shape, the "maximum length between the outer edges in plan view" refers to the length of the diameter. In the present description, a film shape, a foil shape, a film shape, and the like are also included in the "sheet shape".

### Back sheet 11

A back sheet 11 protects a back surface of the power generator 7. That is, the back sheet 11 is a back surface protective layer. As illustrated in Fig. 2, the back sheet 11 is disposed on the opposite side of the light receiving surface of the photovoltaic power generation sheet 1. The back sheet 11 has barrier performance against water vapor and protection performance against external force. The back sheet 11 may be translucent, and does not necessarily need to be translucent. The term "be translucent" as used herein refers to a light transmittance of 10% or more relative to the peak wavelength of light prior to incidence.

The back sheet 11 is flexible. The modulus of longitudinal elasticity of the back sheet 11 is preferably 2400 MPa or more, and more preferably 3000 MPa or more. The modulus of longitudinal elasticity of the back sheet 11 is preferably 4200 MPa or less, more preferably 2100 MPa or less. Examples of the material of the back sheet 11 include synthetic resin such as a thermoplastic resin, a thermosetting resin, a general-purpose plastic, an engineering plastic, and a vinyl resin (for example, polyvinyl chloride). As a material of the back sheet 11, for example, natural resin, rubber, metal, carbon, pulp, or the like may be used in addition to the synthetic resin.

The thickness of the back sheet 11 is preferably 50 µm or more, and more preferably 100 µm or more. The thickness of the back sheet 11 is preferably 2000 µm or less, and more preferably 1000 µm or less. Since the thickness of the back sheet 11 is 50 µm or more and 2000 µm or less, it is easy to set the flexural strength of the photovoltaic power generation sheet 1 to 50 MPa or more and 200 MPa or less. In addition, it is easy to set the flexural modulus of the photovoltaic power generation sheet 1 to 100 MPa or more and 10,000 MPa or less.

### Power generator 7

The power generator 7 uses a photovoltaic effect to generate power by sunlight. The power generator 7 is flexible. The power generator 7 may be provided only one for each photovoltaic power generation sheet 1, or the power generator 7 may be sectioned in a plurality of locations. In one power generator 7, the plurality of power generation cells 12 are monolithically arranged in one direction of the surface direction of the photovoltaic power generation sheet 1 (for example, in Fig. 3(A), arranged in the front direction from the back of the paper). That is, the power generator 7 according to the present embodiment has a monolithic structure in which a plurality of power generation cells 12 constitute one module.

The power generation cell 12 is a photoelectric conversion element using a photovoltaic effect, and is a minimum unit element capable of generating power. In the power generator 7 having the monolithic structure, the plurality of power generation cells 12 are mechanically joined and electrically connected to each other. The power generation amount of one power generator 7 can be changed by increasing or decreasing the number of power generation cells 12.

As illustrated in Fig. 3(A), the power generation cell 12 includes a translucent base member 13, a translucent conductive layer 14, a power generation layer 15, and an electrode 16. The translucent base member 13, the translucent conductive layer 14, the power generation layer 15, and the electrode 16 are stacked in this order along a direction from the barrier sheet 17 toward the back sheet 11. That is, the translucent base member 13 is disposed in a manner of facing the barrier sheet 17, and the electrode 16 is disposed in a manner of facing the back sheet 11.

### Translucent base member 13

The translucent base member 13 supports the translucent conductive layer 14, the power generation layer 15, and the electrode 16. The translucent base member 13 is translucent. For the translucency of the translucent base member 13, the light transmittance is 10% or more with respect to the peak wavelength of light prior to incidence., and is preferably 50% or more, more preferably 80% or more. In the present description, "transparent" is defined as having a light transmittance of 80% or more with respect to the peak wavelength of light prior to incidence.

Examples of the material of the translucent base member 13 include an inorganic material, an organic material, and a metal material. Examples of the inorganic material include quartz glass and alkali-free glass. Examples of the organic material include polyethylene terephthalate (PET), polyethylene naphthalene (PEN), polyethylene, polyimide, polyamide, polyamideimide, liquid crystal polymers, cyclo-olefin polymers, and other plastics and polymer films. Examples of the metal material include stainless steel, aluminum, titanium, and silicon.

The thickness of the translucent base member 13 is not particularly limited as long as the translucent base member 13 can support the translucent conductive layer 14, the power generation layer 15, and the electrode 16, and the thickness of the translucent base member 13 is, for example, 10 µm or more and 300 µm or less.

The translucent base member 13 is a base member required in the manufacturing process of the power generation cell 12. Therefore, the photovoltaic power generation sheet 1 is not necessarily required as a product. For example, the translucent base member 13 may be used only during the manufacturing of the photovoltaic power generation sheet 1, or may be removed after or during the manufacturing. In a case where the translucent base member 13 is removed, a base member that is not translucent may be used instead of the translucent base member 13.

### Translucent conductive layer 14

The translucent conductive layer 14 is a layer that is conductive and functions as a cathode. The translucent conductive layer 14 is translucent. The translucent conductive layer 14 is preferably transparent.

Examples of the translucent conductive layer 14 include indium tin oxide (ITO), fluorine-doped tin oxide (FTO), nesa films, and other transparent materials. The translucent conductive layer 14 is formed on the surface of the translucent base member 13 by, for example, a sputtering method, an ion plating method, a plating method, a coating method, or the like.

In addition, the translucent conductive layer 14 may be configured to be translucent by forming a pattern capable of transmitting light while using a material that is not translucent. Examples of the material that is not translucent include platinum, gold, silver, copper, aluminum, rhodium, indium, titanium, nickel, tin, zinc, and alloys containing these metals. Examples of the pattern capable of transmitting light include a lattice shape, a linear shape, a wavy line shape, a honeycomb shape, and a round hole shape.

The thickness of the translucent conductive layer 14 is preferably, for example, 30 nm or more and 300 nm or less. When the translucent conductive layer 14 has a thickness of 30 nm or more and 300 nm or less, excellent conductivity can be obtained while high flexibility is maintained.

### Power generation layer 15

The power generation layer 15 is a layer that causes photoelectric conversion by light irradiation, producing electrons and holes from excitons generated by light absorption. As illustrated in Fig. 3(B), the power generation layer 15 includes a hole transport layer 151, a photoelectric conversion layer 152, and an electron transport layer 153. The hole transport layer 151, the photoelectric conversion layer 152, and the electron transport layer 153 are stacked in this order along a direction from the translucent conductive layer 14 toward the electrode 16.

### Hole transport layer 151

The hole transport layer 151 extracts holes generated in the photoelectric conversion layer 152 to the translucent conductive layer 14, and prevents electrons generated in the photoelectric conversion layer 152 from moving to the translucent conductive layer 14. As a material of the hole transport layer 151, for example, a metal oxide can be used. Examples of the metal oxide include titanium oxide, molybdenum oxide, vanadium oxide, zinc oxide, nickel oxide, lithium oxide, calcium oxide, cesium oxide, and aluminum oxide. In addition, a delafosite-type compound semiconductor (CuGaO₂), copper oxide, copper thiocyanate (CuSCN), vanadium pentoxide (V₂O₅), graphene oxide, or the like may be used. Furthermore, as a material of the hole transport layer 151, a p-type organic semiconductor or a p-type inorganic semiconductor can also be used.

The thickness of the hole transport layer 151 is, for example, preferably 1 nm or more and 1000 nm or less, more preferably 10 nm or more and 500 nm or less, and still more preferably 10 nm or more and 50 nm or less. As long as the thickness of the hole transport layer 151 is 1 nm or more and 1000 nm or less, hole transport can be realized.

### Photoelectric conversion layer 152

The photoelectric conversion layer 152 (photoactive layer) is a layer that photoelectrically converts absorbed light. The material of the photoelectric conversion layer 152 is not particularly limited as long as the photoelectric conversion layer 152 can photoelectrically convert absorbed light, and for example, amorphous silicon, perovskite, a non-silicon-based material (semiconductor material CIGS), or the like is used. In addition, the photoelectric conversion layer 152 may have a tandem stacked structure that composites these materials. For the photoelectric conversion layer 152 using a non-silicon-based material, a semiconductor material CIGS containing copper (Cu), indium (In), gallium (Ga), and selenium (Se) is used, and the thickness of the photoelectric conversion layer is easily reduced.

Hereinafter, as an example of the photoelectric conversion layer 152, a photoelectric conversion layer 152 using perovskite will be described. The photoelectric conversion layer 152 containing a perovskite compound has an advantage that dependence of power generation efficiency on an angle of incident light (hereinafter, there may be referred to as dependence on the incident angle) is relatively low. As a result, since the photovoltaic power generation sheet 1 according to the present embodiment has low dependence on the incident angle, that is, has less dependency on the gradient of the installation surface, the photovoltaic power generation sheet 1 can be installed in a broader location as compared with that in other solar cells. As a result, in the present embodiment, higher power generation efficiency can be obtained. In addition, since the photovoltaic power generation sheet 1 using perovskite has high power generation efficiency, the photovoltaic power generation sheet 1 can be formed to be relatively thin, and is highly flexible because of the organic substance. Therefore, even when it is installed in a state of being bent along the exterior member 3, the power generation efficiency can be maintained for a long period of time.

The perovskite compound is a structure having a perovskite crystal structure and a crystal similar thereto. The perovskite crystal structure is represented by the composition formula ABX₃. In this composition formula, for example, A represents an organic cation, B represents a metal cation, and X represents a halogen anion. Here, the A site, the B site, and the X site are not limited thereto.

The organic group of the organic cation of the A site is not particularly limited, and examples thereof include alkylammonium derivatives and formamidinium derivatives. The organic cation of the A site may be one kind or two or more kinds.

The metal of the metal cation of the B site is not particularly limited, and examples thereof include Cu, Ni, Mn, Fe, Co, Pd, Ge, Sn, Pb, and Eu. The metal cation of the B site may be one kind or two or more kinds.

The halogen of the halogen anion of the X site is not particularly limited, and examples thereof include F, Cl, Br, and I. The halogen anion of the X site may be one kind or two or more kinds.

The thickness of the photoelectric conversion layer 152 is, for example, preferably 1 nm or more and 1 million nm or less, more preferably 100 nm or more and 50,000 nm or less, and still more preferably 300 nm or more and 1000 nm or less. When the thickness of the photoelectric conversion layer 152 is 1 nm or more and 100,000 nm or less, the photoelectric conversion efficiency is improved.

### Electron transport layer 153

The electron transport layer 153 extracts electrons generated in the photoelectric conversion layer 152 to the electrode 16, and prevents holes generated in the photoelectric conversion layer 152 from moving to the electrode 16. The electron transport layer 153 preferably contains, for example, either a halogen compound or a metal oxide.

Examples of the halogen compound include lithium halide (LiF, LiCl, LiBr, LiI) and sodium halide (NaF, NaCl, NaBr, NaI). Examples of the element of the metal oxide include titanium, molybdenum, vanadium, zinc, nickel, lithium, potassium, cesium, aluminum, niobium, tin, and barium. As a material of the electron transport layer 153, an n-type organic semiconductor or an n-type inorganic semiconductor can also be used.

The thickness of the electron transport layer 153 is, for example, preferably 1 nm or more and 1000 nm or less, more preferably 10 nm or more and 500 nm or less, and still more preferably 10 nm or more and 50 nm or less. As long as the thickness of the electron transport layer 153 is 1 nm or more and 1000 nm or less, electron transport can be realized.

### Electrode 16

The electrode 16 is conductive and functions as an anode. The electrode 16 can extract electrons from the photoelectric conversion layer 152 according to photoelectric conversion generated by the photoelectric conversion layer 152. The electrode 16 may be translucent or may be made of a material that is not translucent. Examples of the material of the electrode 16 include platinum, gold, silver, copper, aluminum, rhodium, indium, titanium, nickel, tin, zinc, and alloys containing these metals.

### Operation of power generation cell 12

When the power generation cell 12 is irradiated with light, the photoelectric conversion layer 152 of the power generation layer 15 absorbs light and performs photoelectric conversion, so that electrons and holes are generated in the photoelectric conversion layer 152. When the electrons are extracted to the electrode 16 (anode) via the electron transport layer 153 and holes are extracted to the translucent conductive layer 14 (cathode) via the hole transport layer 151, a current is extracted from the translucent conductive layer 14 and the electrode 16 (that is, power generation is performed).

### Joint structure of plurality of power generation cells 12, and the like

In the power generator 7, a plurality of power generation cells 12 are joined in one direction. Here, Fig. 3(C) illustrates a cross-sectional view taken along line D-D of Fig. 3 (here, the sealing layer 18, the back sheet 11, and the barrier sheet 17 are omitted). As illustrated in Fig. 3(C), the electrode 16 (anode) of each power generation cell 12 has an extension portion 161 extending from a portion stacked on the electron transport layer 153. The extension portion 161 extends to the translucent conductive layer 14 of adjacent power generation cells 12, and is mechanically joined and electrically connected to the translucent conductive layer 14 of the adjacent power generation cells 12. Adjacent power generation cells 12 are joined by the extension portion 161, so that the translucent conductive layer 14 at one end of the power generator 7 and the electrode 16 at the other end of the power generator 7 are electrically connected to each other.

Since the power generator 7 includes the plurality of power generation cells 12, the amount of electricity extracted from the power generator 7 can be stabilized even when a failure occurs in some of the power generation cells 12.

Note that although the extension portion 161 is included in the electrode 16, the translucent conductive layer 14 (cathode) may include an extension portion 161 extending to the adjacent electrode 16.

In a case where the translucent base member 13 is provided in the power generator 7, it is preferable to support the translucent conductive layer 14, the power generation layer 15, and the electrode 16 of each power generation cell 12 on the common translucent base material 13 as illustrated in Fig. 3(C) from the viewpoint of facilitating the manufacturing of the power generator 7.

The photovoltaic power generation sheet 1 may include a plurality of power generators 7. In this case, the plurality of power generators 7 are arranged along one surface of the photovoltaic power generation sheet 1. The plurality of power generators 7 are electrically connected in series or in parallel. The plurality of power generators 7 are electrically connected by a power distribution line disposed between the back sheet 11 and the barrier sheet 17.

In a case where the plurality of power generators 7 are connected in series, in adjacent power generators 7, the translucent conductive layer 14 at the end of one power generator 7 and the electrode 16 at the end of the other power generator 7 are connected via a power distribution line. In a case where the plurality of power generators 7 are connected in parallel, in adjacent power generators 7, the translucent conductive layers 14 are connected by a power distribution line, and the electrodes 16 are connected by a power distribution line.

In the photovoltaic power generation sheet 1, the plurality of power generators 7 are arranged at intervals in one direction. The distance between adjacent power generators 7 may be more than 0 mm, and is preferably 2 mm or more, more preferably 10 mm or more, and still more preferably 15 mm or more. The distance between adjacent power generators 7 is preferably 100 mm or less, more preferably 50 mm or more, and still more preferably 20 mm or less. In the present embodiment, the distance between adjacent power generators 7 is smaller than the width of the valley portion 33 of the exterior member 3 and larger than the width (maximum width) of the fixing member 5.

### Barrier sheet 17

The barrier sheet 17 protects a surface of the power generator 7 on the front surface side. That is, the barrier sheet 17 is a surface protective layer. The barrier sheet 17 is disposed on a side opposite to the back sheet 11 in the thickness direction of the photovoltaic power generation sheet 1. The barrier sheet 17 includes a light receiving surface of the photovoltaic power generation sheet 1. The barrier sheet 17 is translucent. The barrier sheet 17 is preferably transparent. The barrier sheet 17 has barrier performance against water vapor and protection performance against external force.

The barrier sheet 17 is flexible. The modulus of longitudinal elasticity of the barrier sheet 17 is preferably 2400 MPa or more, and more preferably 3000 MPa or more. In addition, the modulus of longitudinal elasticity of the barrier sheet 17 is preferably 4200 MPa or less, and more preferably 4000 MPa or less. Examples of the material of the barrier sheet 17 include synthetic resin such as a thermoplastic resin, a thermosetting resin, a general-purpose plastic, an engineering plastic, and a vinyl resin (for example, polyvinyl chloride). As a material of the barrier sheet 17, for example, a natural resin, rubber, metal, pulp, or the like may be used in addition to a synthetic resin.

The thickness of the barrier sheet 17 is preferably 50 µm or more, and more preferably 100 µm or more. The thickness of the barrier sheet 17 is preferably 2000 µm or less, and more preferably 1000 µm or less. Since the thickness of the barrier sheet 17 is 50 µm or more and 2000 µm or less, it is easy to set the flexural strength of the photovoltaic power generation sheet 1 to 50 MPa or more and 200 MPa or less.

When the photovoltaic power generation sheet 1 is heated or cooled, the thermal expansion/contraction amount of the barrier sheet 17 is preferably close to the thermal expansion/contraction amount of the back sheet 11. That is, the ratio of the thermal expansion coefficient of the barrier sheet 17 to the thermal expansion coefficient of the back sheet 11 is preferably 6.0 or less, more preferably 3.0 or less, and still more preferably 1.0 or less. On the other hand, the lower limit value of the ratio of the thermal expansion coefficient of the barrier sheet 17 to the thermal expansion coefficient of the back sheet 11 is preferably 0.8 or more, more preferably 0.9 or more, and still more preferably 0.95 or more. With such a configuration, even when the temperature rises due to the influence of sunlight or the temperature drops in the wintertime after installation, the influence of thermal expansion/contraction occurring in the photovoltaic power generation sheet 1 can be reduced. As a result, it is possible to reduce the shear stress generated at the interface between the back sheet 11 and the sealing layer 18 and the interface between the barrier sheet 17 and the sealing layer 18.

### Sealing layer 18

The sealing layer 18 is filled between the barrier sheet 17 and the back sheet 11 in a state where the power generation layer 15 is disposed between the barrier sheet 17 and the back sheet 11. The sealing layer 18 prevents water from entering the power generation layer 15 from around the power generation layer 15. The sealing layer 18 is translucent and is preferably transparent. The sealing layer 18 does not necessarily cover the entire power generator 7. For example, in a case where a part of the power generator 7 is exposed from the sealing layer 18, the exposed portion may be covered with the sealing edge member 19 or the like.

Examples of the material of the sealing layer 18 include ethylene vinyl acetate (EVA), polyolefin, butyl rubber, silicone resin, polyvinyl butyral, acrylic resin, polyisobutylene resin, SBS resin, SIBS resin, epoxy resin, and the like.

The modulus of transverse elasticity of the sealing layer 18 is preferably 0.01 MPa or more and 500 MPa or less, more preferably 0.05 MPa or more and 250 MPa or less, and still more preferably 0.1 MPa or more and 100 MPa or less. In this way, the shear stress in the surface direction due to thermal expansion/contraction caused by a temperature difference between the back sheet 11 and the barrier sheet 17 can be absorbed by the sealing layer 18 being deformed in the surface direction. As a result, it is possible to suppress the occurrence of peeling between the back sheet 11 and the barrier sheet 17 due to the shear stress generated by thermal expansion/contraction.

The back sheet 11 and the barrier sheet 17 are bonded to each other with the sealing layer 18 interposed therebetween, and the bonding strength is preferably 0.1 N/10 mm or more and 10 N/10 mm or less in a peel test. In particular, in a case where the photovoltaic power generation sheet 1 is constructed in a bent state, the shearing stress generated in the photovoltaic power generation sheet 1 becomes larger, and thus, it is possible to effectively suppress peeling for a long period by adopting the bonding strength in the above range in the peel test. The peel test is performed in accordance with JIS Z 0237. The peel test is performed in an environment of 90°C.

From the viewpoint of enhancing the effect of suppressing peeling, the thickness of the sealing layer 18 is preferably 10 µm or more, more preferably 30 µm or more, and still more preferably 50 µm or more. On the other hand, the thickness of the sealing layer 18 is preferably 300 µm or less, more preferably 200 µm or less, and still more preferably 100 µm or less. Setting the thickness of the sealing layer 18 to 10 µm or more can ensure sufficient escape path for the shear stress during thermal expansion/contraction. Setting the thickness of the sealing layer 18 to 300 µm or less allows the weight of the photovoltaic power generation sheet 1 to be reduced, thereby improving the ease of construction and workability.

### Sealing edge member 19

The sealing edge member 19 seals the outer edge over the entire length in a state where the plurality of power generators 7 and the sealing layer 18 are arranged between the back sheet 11 and the barrier sheet 17. As illustrated in Fig. 3, the sealing edge member 19 includes a first bonding portion 191, a second bonding portion 192, and a sealing portion 193 connecting the first bonding portion 191 and the second bonding portion 192. The first bonding portion 191 is bonded to a front surface (upper surface in the drawing) of the barrier sheet 17. The second bonding portion 192 is bonded to the back surface (lower surface in the drawing) of the back sheet 11. The first bonding portion 191, the sealing portion 193, and the second bonding portion 192 are integrally formed.

Examples of the material of the sealing edge member 19 include a tape material made of butyl rubber, silicone rubber, or the like.

In the present embodiment, the sealing edge member 19 is not necessarily required. For example, instead of the sealing edge member 19, an edge portion of the barrier sheet 17 may be bent toward the back sheet 11, and a bent tip may be joined to the back sheet 11. This eliminates the need for the sealing edge member 19.

### Installation structure 100

As illustrated in Fig. 2, the photovoltaic power generation sheet 1 having such a configuration is attached to the exterior member 3. The photovoltaic power generation sheet 1 is disposed across the plurality of convex portions 32 and is fixed to the valley portion 33 by a fixing member 5. At this time, the photovoltaic power generation sheet 1 is not fixed to the plurality of convex portions 32. Since the photovoltaic power generation sheet 1 is flexible, when the photovoltaic power generation sheet 1 is disposed across the plurality of convex portions 32 and fixed to the valley portion 33, the photovoltaic power generation sheet 1 follows the convex portions 32 in the cross section, and the fixed portion is positioned closer to the base side of the convex portion 32 than the top portions 321 of the convex portions 32. Hereinafter, in the photovoltaic power generation sheet 1, a portion fixed by the fixing member 5 may be referred to as an "attachment portion 2".

The fixing member 5 fixes the photovoltaic power generation sheet 1 to the valley portion 33. The fixing member 5 is not particularly limited as long as the photovoltaic power generation sheet 1 can be fixed to the valley portion 33, and examples thereof include a bolt, a screw, a clip sandwiching the photovoltaic power generation sheet 1, a bonder, a magnet, a pin, a nail, a weight, a hook and loop fastener, a double-sided tape, and the like. As the fixing member 5, a bonder, a magnet, or a weight, which is the fixing member 5 that does not require a hole in the exterior member 3, is preferably used from the viewpoint of the waterproof property of the exterior member 3. In addition, it is preferable to use a bolt and a screw from the viewpoint of construction and attachment strength. In the present embodiment, a bolt will be described as an example of the fixing member 5.

The fixing member 5 is attached to the valley portion 33. The fixing member 5 is preferably attached to a position (this may be referred to as a "position corresponding to the tight frame 42") overlapping the tight frame 42 in the exterior member 3. As a result, the attachment strength of the fixing member 5 to the exterior member 3 can be improved. As a result, for example, the negative pressure strength of the photovoltaic power generation sheet 1 can be increased, and peeling of the photovoltaic power generation sheet 1 from the exterior member 3 can be suppressed.

As illustrated in Fig. 1, the attachment portion 2 of the photovoltaic power generation sheet 1 is a through hole 21 in the present embodiment. A plurality of through holes 21 are formed at regular intervals along a portion between adjacent power generators 7. The plurality of through holes 21 are arranged at regular intervals in the lateral direction. That is, in the present embodiment, since the attachment portion 2 is formed in a portion other than the power generator 7, a portion protruding from the surface of the photovoltaic power generation sheet 1 in the fixing member 5 (here, the head of the bolt) can be positioned in a portion other than the power generator 7.

Therefore, in the present embodiment, not only the power generator 7 can be positioned at the position corresponding to the convex portion 32, but also the shadow generated by the fixing member 5 can be prevented from overlapping the power generator 7 as much as possible. As a result, it is possible to arrange the power generator 7 at a position easily exposed to sunlight while suppressing a decrease in power generation efficiency due to the shadow generated by the fixing member 5, and to obtain high power generation efficiency.

The pitch of the plurality of through holes 21 formed along the portion between the adjacent power generators 7 is, for example, 50 mm or more and 200 mm or less, and more specifically, 100 mm or more and 150 mm or less.

When the fixing member 5 is a bonder, the attachment portion 2 does not need to be the through hole 21, and thus the power generator 7 may be positioned at a position corresponding to the valley portion 33. In this case, for example, one power generator 7 may be disposed across two adjacent convex portions 32. In this case, one region (glue margin) to which the bonder is applied is the attachment portion 2 of the photovoltaic power generation sheet 1.

In a case where the fixing member 5 is a magnet, for example, the photovoltaic power generation sheet 1 may be sandwiched between the magnet and the exterior member 3. In this case, the magnet is disposed in a portion between adjacent power generators 7. In this aspect, a portion where the magnet is placed among the portions between adjacent power generators 7 is the attachment portion 2 of the photovoltaic power generation sheet 1. In a case where the fixing member 5 is a magnet, it is preferable that the tight frame 42 or the exterior member 3 is made of a magnetic material.

Further, it is preferable that the end portion in the lateral direction of the photovoltaic power generation sheet 1 are not positioned on the valley portions 33. That is, it is preferable that the attachment portion 2 is not provided at the end portion in the lateral direction of the photovoltaic power generation sheet 1, in other words, it is preferable that the attachment portion 2 is positioned at the intermediate portion in the lateral direction of the photovoltaic power generation sheet 1. The term "end portion in the lateral direction of the photovoltaic power generation sheet 1" as used herein refers to a position corresponding to the sealing edge member 19 in the present embodiment, and the term "intermediate portion in the lateral direction of the photovoltaic power generation sheet 1" refers to a portion between the sealing edge members 19 (portion covered with the barrier sheet 17) in the lateral direction.

When it rains, rainwater collects in a portion above the valley portion 33 which is the lowest position on the upper surface of the photovoltaic power generation sheet 1. This portion is referred to as a "drain portion 6". The drain portion 6 extends in the water flow direction and is inclined downward to the water down side. The rainwater collected in the drain portion 6 flows along the water flow direction, and flows from the end portion on the water down side of the photovoltaic power generation sheet 1 onto the valley portion 33.

Since the drain portion 6 is formed of the intermediate portion in the lateral direction of the photovoltaic power generation sheet 1, that is, a part of the upper surface of the barrier sheet 17, the portion of the sealing edge member 19 where water is relatively likely to be immersed can be kept away from the drain portion 6. Therefore, it is possible to suppress water from entering the power generator 7 of the photovoltaic power generation sheet 1.

Here, the fixing member 5 passed through the through hole 21 is provided with a water-blocking member (for example, sealing member, caulking member, gasket, and the like). Therefore, in the present embodiment, even when the through hole 21 is provided in the drain portion 6, water immersion from the through hole 21 is suppressed. Even when the water-blocking member is broken and water enters from the through hole 21, not only the through hole 21 is formed in a portion corresponding to the sealing layer 18, but also the through hole 21 and the power generator 7 are separated from each other by a predetermined distance or more, so that water entering the power generator 7 is suppressed.

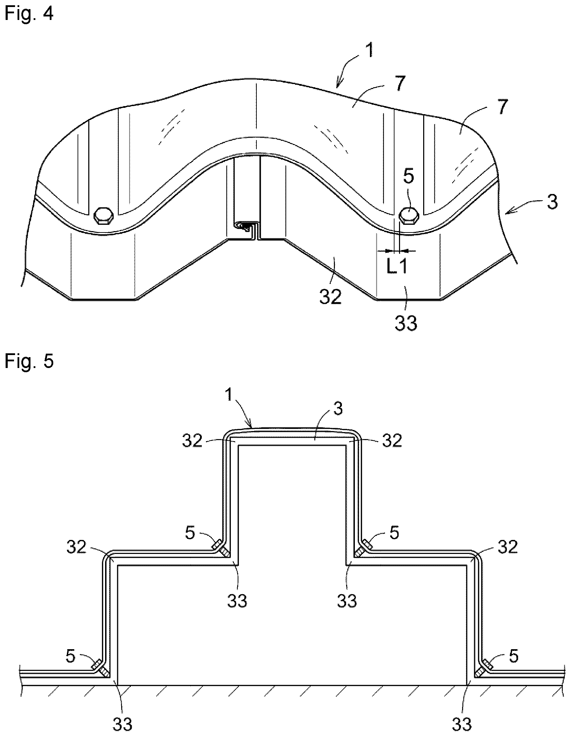

Here, Fig. 4 is a perspective view of the end portions on the water down side of the exterior member 3 and the photovoltaic power generation sheet 1 as viewed from above. In the present embodiment, a minimum distance L1 between the fixing member 5 and the power generator 7 positioned closest to the fixing member 5 is designed to be 5 mm or more, preferably 15 mm or more. Since the distance L1 is designed to be 15 mm or more, the distance between the through hole 21 and the power generator 7 can be maintained at a predetermined distance or more. As a result, even when water enters the through hole 21 serving as the attachment portion 2, water entering the power generator 7 is suppressed. The upper limit value of the distance L1 is not particularly limited, and is, for example, 50 mm or less.

As illustrated in Fig. 2, the maximum value of the gap S1 between the photovoltaic power generation sheet 1 and the outer surface of the exterior member 3 in the cross section orthogonal to the water flow direction is preferably 20 mm or less, and more preferably 15 mm or less. In the present embodiment, the gap S1 is set to be equal to or smaller than the protruding dimension of the fastened portion 322. When the maximum value of the gap S1 is 15 mm or less, it is possible to suppress the wind flowing along the surface of the exterior member 3 from being blown between the photovoltaic power generation sheet 1 and the outer surface of the exterior member 3, and it is possible to suppress fluttering of the photovoltaic power generation sheet 1. Note that the photovoltaic power generation sheet 1 and the outer surface of the exterior member 3 may be as close as possible, and the lower limit value of the maximum value of the gap between the photovoltaic power generation sheet 1 and the outer surface of the exterior member 3 may be 0 mm or more.

### Construction method

Next, an example of a construction method for attaching the photovoltaic power generation sheet 1 according to the present embodiment to the exterior member 3 will be described.

First, the worker places the photovoltaic power generation sheet 1 on the exterior member 3 of the building. The exterior member 3 of the building may be an existing exterior member 3 or an exterior member 3 before being attached to the framework.

The worker flexes the photovoltaic power generation sheet 1 placed on the exterior member 3, and bends the photovoltaic power generation sheet 1 along the convex portion 32. Then, the worker inserts a bolt serving as the fixing member 5 into the through hole 21 of the photovoltaic power generation sheet 1 from above, and screws the bolt into the valley portion 33. A female screw may be formed in advance in the valley portion 33, or a nut may be welded.

Thereafter, the worker performs water-blocking treatment on the bolt and the through hole 21 using a water-blocking member. This completes the construction of the photovoltaic power generation sheet 1. As described above, in the present embodiment, since the photovoltaic power generation sheet 1 is flexible, even when the worker drops the photovoltaic power generation sheet 1 on the exterior member 3 at the time of construction, the damage of the exterior member 3 can be suppressed. This allows the worker to improve workability.

### Operation and effect

As described above, the installation structure 100 of the photovoltaic power generation sheet 1 according to the present embodiment includes the photovoltaic power generation sheet 1 having a flexural strength of 50 MPa or more and 200 MPa or less, and the fixing member 5 that fixes the photovoltaic power generation sheet 1 to a portion between adjacent convex portions 32, so that the surface area of the photovoltaic power generation sheet 1 per unit area of the roof surface can be made as large as possible as compared with a flat solar cell panel having high rigidity.

In addition, since the portion of the photovoltaic power generation sheet 1 fixed to the fixing member 5 is positioned closer to the base side of the convex portion 32 than the top portion 321 of the convex portion 32, the portion of the power generator 7 in the photovoltaic power generation sheet 1 can be arranged in such a manner of protruding along the convex portion 32 that is likely to be exposed to sunlight.

Further, since the photovoltaic power generation sheet 1 is not fixed to the plurality of convex portions 32, it is possible to prevent a portion on the convex portions 32 which are likely to be exposed to sunlight from overlapping the shadow of the fixing member 5.

Further, the photovoltaic power generation sheet 1 includes a plurality of power generators 7 containing a perovskite compound. Incidentally, it is known that the photovoltaic power generation sheet 1 having the power generator 7 containing the perovskite compound has small dependence on the incident angle. When the photovoltaic power generation sheet 1 is attached to the exterior member 3 having a plurality of convex portions 32, the angle of the surface of the photovoltaic power generation sheet 1 with respect to the sunlight continuously changes, but by using the photovoltaic power generation sheet 1 containing the perovskite compound, it is possible to suppress the deterioration of the power generation efficiency.

Further, since the fixing member 5 is attached to the portion other than the power generator 7 in the photovoltaic power generation sheet 1, it is possible to suppress the influence of the fixing member 5 on the power generation efficiency.

In the photovoltaic power generation sheet 1, the intermediate portion of the barrier sheet 17 is fixed by the fixing member 5, and the intermediate portion constitutes the drain portion 6, so that water is less likely to enter the power generator 7.

### Modifications

The above embodiment is merely one of various embodiments of the present disclosure. The embodiment can be variously changed according to the design and the like as long as the object of the present disclosure can be achieved. Modifications of the embodiment will be listed below. Modifications described below can be appropriately combined and applied.

### First modification

In the exterior member 3 of the above embodiment, the convex portion 32 and the valley portion 33 are arranged in the lateral direction, and as illustrated in Fig. 5, the convex portion 32 and the valley portion 33 may be arranged in a direction inclined with respect to the horizontal plane.

In the exterior member 3, convex portions 32 and valley portions 33 are repeatedly formed. Each of the convex portions 32 is formed in an L shape. Each of valley portions 33 is a portion to which the adjacent convex portions 32 are connected, and is configured by a corner portion. Thus, the exterior member 3 is formed in a stepwise shape.

The installation structure 100 is fixed to the valley portion 33 by the fixing member 5 in a state where the photovoltaic power generation sheet 1 is curved along the plurality of convex portions 32 in the cross section.

### Second modification

The photovoltaic power generation sheet 1 of the above embodiment is attached to the exterior member 3 by a plurality of fixing members 5, and the photovoltaic power generation sheet 1 of the present disclosure may be attached to the exterior member 3 in the following aspect.

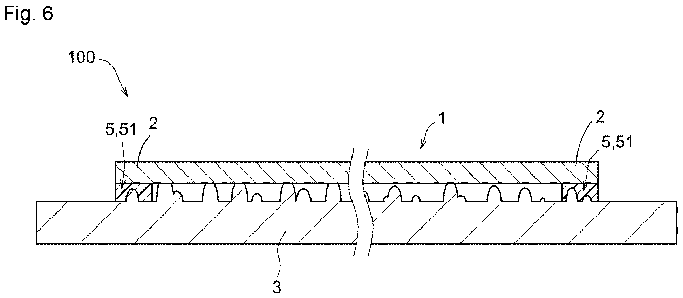

As illustrated in Fig. 6, the surface of the exterior member 3 may have slight unevenness. The arithmetic average roughness of the surface of the exterior member 3 is preferably 5 mm or less, more preferably 1 mm or less, and still more preferably 0.5 mm or less. On the other hand, the arithmetic average roughness of the surface of the exterior member 3 is preferably 100 nm or more, more preferably 10 µm or more, and still more preferably 100 µm or more. By setting the surface roughness to 5 mm or less, blowing of wind from the end portion of the photovoltaic power generation sheet 1 can be suppressed, and the plane of the photovoltaic power generation sheet 1 can be easily maintained. Therefore, the photovoltaic power generation sheet 1 can be installed without hindering the flow of rainwater in the water down direction on the photovoltaic power generation sheet 1, and accumulation of dirt can be suppressed. In addition, by setting the surface roughness to 100 nm or more, as described later, in a case where the photovoltaic power generation sheet 1 is attached using a bonder 51 serving as the fixing member 5, a strong attachment strength is easily obtained due to the anchor effect. The arithmetic average roughness is measured in accordance with JIS B 0601.

The bonder 51 is preferably used as the fixing member 5. The bonder 51 is provided between the attachment portion 2 of the photovoltaic power generation sheet 1 and the exterior member 3, and adheres the photovoltaic power generation sheet 1 to the exterior member 3. With such a configuration, the gap between the exterior member 3 and the outer peripheral portion of the photovoltaic power generation sheet 1 can be closed by the bonder 51, and the vibration of the photovoltaic power generation sheet 1 due to wind can be suppressed. In the photovoltaic power generation sheet 1, the bonder 51 may be provided only on the valley portion 33, or may be provided on the valley portion 33 and the convex portions 32. In particular, in a case of the exterior member 3 (for example, a roof deck, a corrugated slate, and the like) in which the top portion 321 does not exist at the upper end of the convex portion 32, the bonder 51 can be disposed over the entire circumference between the outer peripheral portion of the photovoltaic power generation sheet 1, and the valley portion 33 and the convex portion 32.

The viscosity of the bonder 51 is preferably 100cP or more, more preferably 800cP or more, and still more preferably 1000cP or more. On the other hand, the viscosity of the bonder 51 is preferably 10×10⁷cP or less, more preferably 10×10⁶cP or less, and still more preferably 10×10⁴cP or less. When the viscosity of the bonder 51 is 100cP or more, a gap between the photovoltaic power generation sheet 1 and the exterior member 3 is easily filled. When the viscosity of the bonder 51 is 10×10⁷cP or less, the handleability of the bonder 51 is hardly impaired.

The bonder 51 preferably has a function of attenuating vibration from the exterior member 3. The loss factor (tanδ) of the bonder 51 against vibration is preferably 0.01 or more, more preferably 0.05 or more, and still more preferably 0.07 or more. On the other hand, the loss factor (tanδ) is preferably 0.3 or less, more preferably 0.25 or less, and still more preferably 0.2 or less. By setting the loss factor to 0.01 or more, the vibration of the exterior member 3 can be effectively attenuated, and the photovoltaic power generation sheet 1 can be suppressed from vibrating. On the other hand, by setting the loss factor to 0.3 or less, the installation state of the photovoltaic power generation sheet 1 can be stabilized. When the loss factor becomes too large, it becomes difficult to obtain the stability of the installation state of the photovoltaic power generation sheet 1 with respect to the exterior member 3, and in particular, as the gradient of the exterior member 3 becomes large, the photovoltaic power generation sheet 1 is likely to slide downward.

The loss factor here indicates the amount of vibration energy transmitted from the exterior member 3 to the photovoltaic power generation sheet 1 via the bonder, and is calculated by the storage elastic modulus/loss elastic modulus of the bonder 51. The measurement is performed in accordance with JIS K 7244-10 using a rheometer.

The thickness of the bonder 51 is preferably 0.1 mm or more, more preferably 1 mm or more, and still more preferably 3 mm or more. On the other hand, the thickness of the bonder 51 is preferably 20 mm or less, more preferably 15 mm or less, and still more preferably 10 mm or less. By setting the thickness of the bonder 51 to 0.1 mm or more, vibrations transmitted from the exterior member 3 to the photovoltaic power generation sheet 1 can be effectively suppressed. By setting the thickness of the bonder 51 to 20 mm or less, a weight load on the exterior member 3 can be reduced.

The modulus of transverse elasticity of the bonder 51 is preferably 0.1 MPa or more, more preferably 0.5 MPa or more, and still more preferably 1 MPa or more. On the other hand, the modulus of transverse elasticity of the bonder 51 is preferably 100 MPa or less, more preferably 50MPs or less, and still more preferably 10 MPa or less. When the modulus of transverse elasticity of the bonder 51 is 0.1 MPa or more and 100 MPa or less, the photovoltaic power generation sheet 1 is likely to deform along the shape of the exterior member 3, and the area of the roof surface is likely to be effectively utilized.

In the attachment structure 100 in which the photovoltaic power generation sheet 1 is attached to the exterior member 3 with the bonder 51, the peel strength of the photovoltaic power generation sheet 1 is preferably 0.1 N/cm or more. The peel strength referred to herein refers to a peel strength at an environmental temperature of 90°C. In addition, the peel strength is the peel strength at the time of construction.

As the bonder 51, for example, a resin composition containing at least one or more selected from a vinyl acetate resin, ethylene-acetic acid, a vinyl resin, an epoxy resin, a cyanoacrylate resin, an acrylic resin, a chloroprene rubber, styrene, a butadiene rubber, a polyurethane resin, a silicone resin, and a modified silicone resin can be used. In addition, the form of the bonder 51 may be a form in which the bonder 51 is applied at a construction site, or may be provided on the photovoltaic power generation sheet 1 or the exterior member 3 in advance. The bonder 51 may have a sheet shape. When the bonder 51 having a sheet shape is brought into the construction site, the bonding surface is protected by a release sheet, and the release sheet is peeled off and used during construction.

In the attachment structure 100 of the photovoltaic power generation sheet 1, only the outer peripheral portion may be bonded by the bonder 51, or the entire surface of the photovoltaic power generation sheet 1 may be bonded as described later. Here, the effect of suppressing the vibration of the photovoltaic power generation sheet 1 by wind or the like can also be obtained by bonding only the outer peripheral portion of the photovoltaic power generation sheet 1 with the bonder 51. The outer peripheral portion of the photovoltaic power generation sheet 1 refers to a range having a predetermined width from the outer peripheral edge of the photovoltaic power generation sheet 1 to a position advanced inward by a certain distance. The width in which the bonder 51 is provided on the outer peripheral portion of the photovoltaic power generation sheet 1 is preferably 5 mm or more, more preferably 100 mm or more, and still more preferably 150 mm or more. On the other hand, the width in which the bonder 51 is provided on the outer peripheral portion of the photovoltaic power generation sheet 1 is preferably 250 mm or less, more preferably 200 mm or less, and still more preferably 175 mm or less. As long as the width in which the bonder 51 is provided on the outer peripheral portion of the photovoltaic power generation sheet 1 is 5 mm or more, the effect of effectively suppressing vibration of the photovoltaic power generation sheet 1 can be obtained. As long as the width in which the bonder 51 is provided on the outer peripheral portion of the photovoltaic power generation sheet 1 is 250 mm or less, the amount of the bonder 51 used can be reduced, and the cost can be reduced.

As described above, according to the present modification, since the photovoltaic power generation sheet 1 can be suppressed from vibrating in the wind, the angle of the photovoltaic power generation sheet 1 with respect to sunlight can be stably maintained. Therefore, the power generation efficiency of the photovoltaic power generation sheet 1 can be stably maintained.

### Third modification

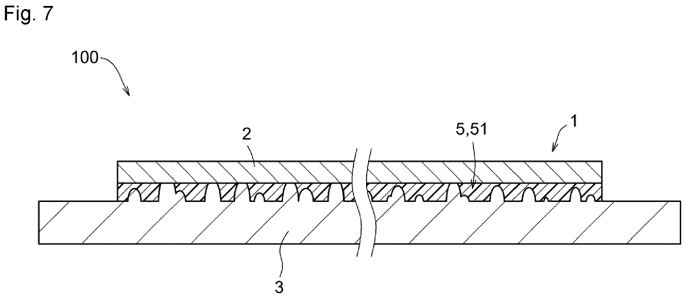

In the present modification, the bonder 51 is provided on the outer peripheral portion of the photovoltaic power generation sheet 1, and for example, as illustrated in Fig. 7, the bonder 51 may be provided between the entire photovoltaic power generation sheet 1 and the exterior member 3. The entire photovoltaic power generation sheet 1 may be bonded to the exterior member 3 by the bonder 51.

According to the installation structure 100 according to the present modification, the entire photovoltaic power generation sheet 1 can be bonded to the exterior member 3 by the bonder 51 in a state where the slight unevenness of the exterior member 3 on the lower side of the entire photovoltaic power generation sheet 1 is filled with the bonder 51. Accordingly, it is possible to prevent generation of a gap between the entire photovoltaic power generation sheet 1 and the exterior member 3. Thus, vibration of the photovoltaic power generation sheet 1 due to wind can be further suppressed. Therefore, since the angle of the photovoltaic power generation sheet 1 with respect to sunlight can be more stably maintained, the power generation efficiency of the photovoltaic power generation sheet 1 can be more stably maintained.

### Fourth modification

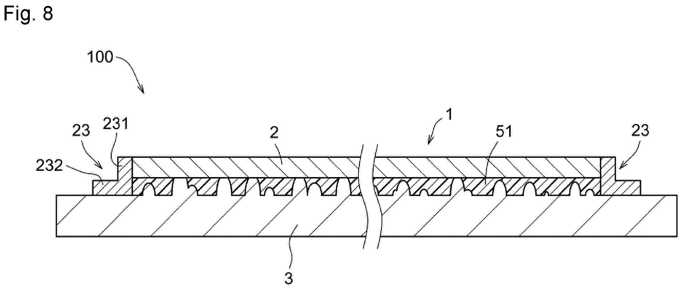

As illustrated in Fig. 8, the attachment structure 100 may have a cover member 23 that covers a gap between the photovoltaic power generation sheet 1 and the exterior member 3. Thus, vibration of the photovoltaic power generation sheet 1 due to wind can be further suppressed.

The cover member 23 preferably has ultraviolet ray blocking property. The cover member 23 extends along the outer peripheral portion of the photovoltaic power generation sheet 1. The cover member 23 is bent at the center in the width direction and is formed in a substantially L shape. The cover member 23 includes a first portion 231 and a second portion 232 connected to the first portion 231, and the first portion 231 and the second portion 232 are orthogonal to each other. The cover member 23 is fixed to the exterior member 3 in which the first portion 231 is along the outer peripheral edge of the photovoltaic power generation sheet 1 and the second portion 232 is outside the photovoltaic power generation sheet 1. Thus, the cover member 23 can cover between the outer peripheral portion of the photovoltaic power generation sheet 1 and the exterior member 3.

According to the installation structure 100 according to the present modification, since the cover member 23 can block ultraviolet rays, it is possible to suppress deterioration of the bonder 51 due to ultraviolet rays. Therefore, the state in which the photovoltaic power generation sheet 1 and the exterior member 3 are bonded by the bonder 51 can be maintained for a long period of time.

### Fifth modification

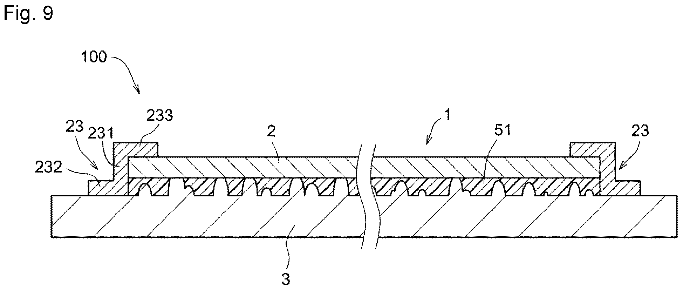

The cover member 23 may have an aspect as illustrated in Fig. 9. The cover member 23 of the present modification includes a first portion 231, a second portion 232, and a third portion 233. In the cover member 23, the first portion 231, the second portion 232, and the third portion 233 are connected in series, and are formed in a crank shape. Since the first portion 231 and the second portion 232 are the same as those of the fourth modification, the description thereof will be omitted. It is preferable that the cover member 23 has an ultraviolet ray blocking property similarly to the cover member 23 of the fourth modification.

The third portion 233 is orthogonal to the second portion 232. The third portion 233 faces the surface of the outer peripheral portion of the photovoltaic power generation sheet 1. The third portion 233 is preferably bonded to the surface of the outer peripheral portion of the photovoltaic power generation sheet 1.

In the cover member 23, the second portion 232 is along the outer peripheral end surface of the photovoltaic power generation sheet 1, the first portion 231 is fixed to the exterior member 3 outside the photovoltaic power generation sheet 1, and the third portion 233 is fixed to the surface of the outer peripheral portion of the photovoltaic power generation sheet 1. Thus, a space between the outer peripheral portion of the photovoltaic power generation sheet 1 and the exterior member 3 is covered.

According to the installation structure 100 according to the present modification, since the cover member 23 can block ultraviolet rays, it is possible to suppress deterioration of the bonder 51 due to ultraviolet rays. Therefore, the state in which the photovoltaic power generation sheet 1 and the exterior member 3 are bonded by the bonder 51 can be maintained for a long period of time.

### Modification example common to fourth and fifth Modifications

Regarding the fourth and fifth modifications, commonly applicable modifications will be listed. The modifications listed below can be appropriately applied not only to the above embodiment but also to the first to fifth modifications.

As the material of the cover member 23 of the fourth and fifth modifications, for example, a frame made of metal such as aluminum can be used. In a case where the cover member 23 is a metal frame, the cover member 23 is fixed to the exterior member 3 with, for example, a bolt, a bonder, or the like.

In the attachment structure 100, the entire circumference of the outer peripheral portion of the photovoltaic power generation sheet 1 is preferably surrounded by the cover member 23. In this way, it is possible to suppress deterioration of the entire bonder 51. The attachment structure 100 may be attached to the outer peripheral portion of the photovoltaic power generation sheet 1 by combining a plurality of cover members 23 having a linear shape in plan view, or may be attached to the outer peripheral portion of the photovoltaic power generation sheet 1 using a cover member 23 having a rectangular frame-shape. In the attachment structure 100, a part of the entire circumference of the outer peripheral portion of the photovoltaic power generation sheet 1 may not be covered with the cover member 23. Note that the cover member 23 is preferably installed in a structure along the shape of the installation surface. This makes it possible to more effectively shield light and to suppress deterioration of the bonding layer for a long period of time. On the other hand, a cover member may be partially provided. For example, by providing the cover member 23 only in the vicinity of a fixed portion where the stress due to wind or/and the weight of the photovoltaic power generation sheet 1 is likely to be generated, not only the deterioration of the portion that is likely to deteriorate can be effectively suppressed, but also the material cost can be reduced.

The contact pressure by the cover member 23 with respect to the outer peripheral portion of the photovoltaic power generation sheet 1 preferably falls within a certain range. The contact pressure of the cover member 23 with respect to the photovoltaic power generation sheet 1 is preferably 0.5 MPa or more, more preferably 1 MPa or more, and still more preferably 2.5 MPa or more. On the other hand, the contact pressure of the cover member 23 with respect to the photovoltaic power generation sheet 1 is preferably 25 MPa or less, more preferably 15 MPa or less, and still more preferably 10 MPa or less. By setting the contact pressure of the cover member 23 with respect to the photovoltaic power generation sheet 1 to 0.5 MPa or more and 25 MPa or less, even when the cover member 23 is attached, it is possible to reinforce the installation of the photovoltaic power generation sheet 1 and suppress fluttering of the end portion of the photovoltaic power generation sheet 1 due to wind or the like without hindering deformation of the photovoltaic power generation sheet 1.

In the cover member 23, a ridge may be provided in a portion in contact with the photovoltaic power generation sheet 1. The ridges are formed along the longitudinal direction of the cover member 23. The ridge compresses the surface of the outer peripheral portion of the photovoltaic power generation sheet 1. As a result, it is possible to improve water-blocking performance against water immersion from the outer peripheral portion of the photovoltaic power generation sheet 1 by the contact pressure of the ridge with respect to the photovoltaic power generation sheet 1. The crushing filtration of the photovoltaic power generation sheet 1 by the ridge is preferably 1% or more, more preferably 5% or more, and still more preferably 100 or more with respect to the thickness of the photovoltaic power generation sheet 1. On the other hand, the crushing filtration of the photovoltaic power generation sheet 1 by the ridge is preferably 25% or less, more preferably 20% or less, and still more preferably 150 or less with respect to the thickness of the photovoltaic power generation sheet 1. By setting the crushing filtration the photovoltaic power generation sheet 1 by the ridge to 1% or more and 25% or less of the thickness of the photovoltaic power generation sheet 1, it is possible to improve the water-blocking performance and prevent the deformation of the photovoltaic power generation sheet 1 from being hindered.

The convex portion 32 and the valley portion 33 on the surface (installation surface) of the exterior member 3 may be curved along the longitudinal direction or may have unevenness along the longitudinal direction. In this case, the maximum curvature radius of the photovoltaic power generation sheet 1 is preferably 50 mm or more, more preferably 75 mm or more, and still more preferably 100 mm or more. By setting the maximum curvature radius of the photovoltaic power generation sheet 1 to 50 mm or more, it is possible to install the photovoltaic power generation sheet 1 on the exterior member 3 having various shapes while suppressing breakage of the photovoltaic power generation sheet 1.

The cover member 23 may be made of a material that cures after construction or a high-viscosity material. In this case, examples of the cover member 23 include joint materials such as cement, mortar, a caulking material, a high-viscosity resin, and gypsum. The viscosity of the material is preferably 0.1 Pa·s or more, more preferably 10 Pa·s or more. On the other hand, the viscosity of the material is preferably 10,000 Pa·s or less, and preferably 1000 Pa·s or less. By setting the viscosity of the material to 0.1 Pa·s or more, the shape of the cover member 23 can be retained in both the direction along the plane of the photovoltaic power generation sheet 1 and the direction perpendicular to the plane, and the gap between the photovoltaic power generation sheet 1 and the exterior member 3 can be effectively closed. In addition, by setting the viscosity of the material to 10,000 Pa·s or less, the material can be easily applied during construction, and construction can be improved.

When the cover member 23 is made of a material that is cured after construction or a material having a high viscosity, the distance from the edge of the photovoltaic power generation sheet 1 to the end portion on the inner side of the cover member 23 is preferably 5 mm or more, more preferably 100 mm or more, and still more preferably 150 mm or more. On the other hand, the distance is preferably 250 mm or less, more preferably 200 mm or less, and still more preferably 175 mm or less. By setting the distance from the edge of the photovoltaic power generation sheet 1 to the end portion on the inner side of the cover member 23 to 5 mm or more and 250 mm or less, the cover member 23 can be used without waste while the vibration of the photovoltaic power generation sheet 1 can be appropriately suppressed, and the weight load on the exterior member 3 can be reduced, so that installation on the fragile exterior member 3 is also stabilized.

When the gap between the outer peripheral portion of the photovoltaic power generation sheet 1 and the exterior member 3 is filled with the bonder 51 and/or the cover member 23, an airtight cavity surrounded by the bonder 51 and/or the cover member 23 is generated between the photovoltaic power generation sheet 1 and the exterior member 3. Therefore, when the air in the cavity expands or contracts due to a temperature change, a force due to air pressure is applied to the photovoltaic power generation sheet 1, and the photovoltaic power generation sheet 1 may be broken. In order to suppress this, it is preferable that the bonder 51 and/or the cover member 23 be made of a porous material, or air holes are formed in the bonder 51 and/or the cover member 23. The total opening area of the air holes is preferably 20mm² or more, more preferably 25mm² or more, and still more preferably 50mm² or more. On the other hand, the total opening area of the air holes is preferably 200mm² or less, more preferably 150mm² or less, and still more preferably 100mm² or less. By setting the total opening area of the air holes to 20mm² or more, the air in the cavity expanded or contracted by the temperature change and the outside air can be appropriately exchanged, and the force received by the photovoltaic power generation sheet 1 from the air in the cavity can be reduced. In addition, by setting the total opening area of the air holes to 200mm² or less, rainwater can be suppressed from entering the cavity, and deterioration of the photovoltaic power generation sheet 1 due to the rainwater can be suppressed. The air holes are preferably located on the lower side in the gradient direction of the exterior member 3.

In a case where the space between the photovoltaic power generation sheet 1 and the exterior member 3 is large and it is difficult to cover the outer peripheral portion with the bonder 51 or the cover member 23 (joint material), for example, a lid member such as a hard resin, a metal, or a ceramic may be attached to the outer peripheral portion.

In the cover member 23, it is preferable to perform chamfering processing (C chamfering or R chamfering) on a corner portion in contact with the photovoltaic power generation sheet 1. As a result, even when a force acts on the contact portion between the photovoltaic power generation sheet 1 and the cover member 23 by wind or the like, for example, in the vertical direction, it is possible to reduce a local concentration of the force applied from the cover member 23 to the photovoltaic power generation sheet 1. In particular, since the deformation of the photovoltaic power generation sheet 1 that is flexible is difficult to predict unlike a rigid solar cell, the installation state is stabilized for a long period by reducing the local force on the contact surface with the cover member 23. In addition, an elastic member may be disposed between the cover member 23 and the photovoltaic power generation sheet 1. The elastic member is not particularly limited, and examples thereof include rubber, soft resin, metal washer, spring, cloth, and the like.

The bonder 51 between the photovoltaic power generation sheet 1 and the exterior member 3 may be composed of only a single bonder, or a filler may be disposed between the photovoltaic power generation sheet 1 and the exterior member 3, and a first bonding layer for bonding the exterior member 3 and the filler and a second bonding layer for bonding the filler and the photovoltaic power generation sheet 1 may be provided. The viscosity of the filler is preferably, for example, 800cP or more.

A plurality of types of fixing members 5 may be used simultaneously. For example, in addition to the bonder 51 disposed between the photovoltaic power generation sheet 1 and the exterior member 3, for example, a bolt, a rivet, a clip, a magnet, a pin, a nail, a weight, or the like may be used. Among them, it is preferable to use a magnet or a weight that does not require a hole from the viewpoint of waterproofness. In addition, it is preferable to use a bolt and a rivet from the viewpoint of construction and attachment strength.

In addition, the bonder 51 reduces vibration transmitted from the exterior member 3 to the photovoltaic power generation sheet 1 and suppresses vibration of the photovoltaic power generation sheet 1 due to wind or the like, and in a case where the exterior member 3 is difficult to vibrate, only a configuration (For example, the cover member 23) for suppressing vibration of the photovoltaic power generation sheet 1 due to wind or the like may be adopted as the fixing member 5 without providing the bonder 51. It is preferable that the bonder 51 is designed to mainly play a role of fixing the photovoltaic power generation sheet 1 to the exterior member 3, and the cover member 23 is designed to play a role of suppressing vibration of the photovoltaic power generation sheet 1 due to wind or the like.

### Sixth modification

A spacer member for preventing the photovoltaic power generation sheet 1 from coming into contact with the convex portion 32 of the exterior member 3 may be disposed between the photovoltaic power generation sheet 1 and the convex portion 32 of the exterior member 3. As a result, even when the photovoltaic power generation sheet 1 is installed across the convex portions 32, it is possible to prevent the photovoltaic power generation sheet 1 from being damaged by the convex portions 32.

### Spacer member 8

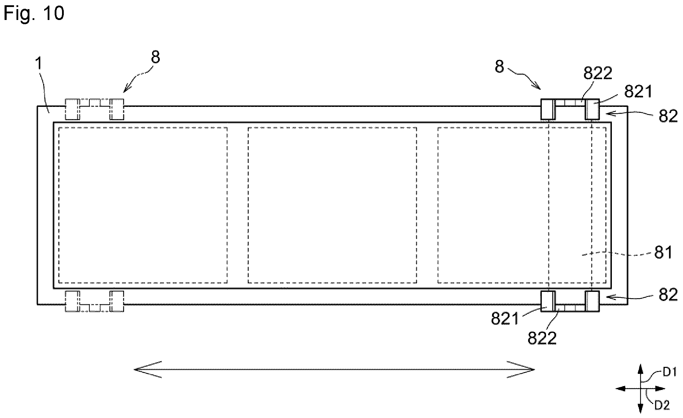

As illustrated in Fig. 10, a spacer member 8 is attached to the photovoltaic power generation sheet 1. The spacer member 8 includes a spacer 81 and a spacer spacer attachment portion 82. The spacer member 8 may be attached to the photovoltaic power generation sheet 1 in a retrofitting manner at a construction site or may be attached at the time of factory shipment.

### Spacer 81

The spacer 81 is disposed between the convex portions 32 of the exterior member 3 and the photovoltaic power generation sheet 1. Since the spacer 81 is disposed between the convex portion 32 having a corner portion and the photovoltaic power generation sheet 1, it is possible to reduce an external force applied to the photovoltaic power generation sheet 1 from the corner portion. The thickness of the spacer 81 is, for example, preferably 1 mm or more, more preferably 3 mm or more, and still more preferably 5 mm or more. On the other hand, the upper limit of the thickness of the spacer 81 is preferably 20 mm or less, more preferably 15 mm or less, and still more preferably 10 mm or less. In this way, it is possible to suppress damage at the contact portion between the corner portion and the photovoltaic power generation sheet 1.

The spacer 81 preferably keeps the corner portion of the convex portion 32 and the photovoltaic power generation sheet 1 in a non-contact state. In order to keep the corner portion and the photovoltaic power generation sheet 1 in a non-contact state, in the present embodiment, the spacer 81 is formed extending from one end portion to the other end portion of the photovoltaic power generation sheet 1 in the first direction D1. That is, the spacer 81 extends over the entire length in the width direction of the photovoltaic power generation sheet 1. In this case, the spacer 81 may be longer than the width of the photovoltaic power generation sheet 1 as long as the spacer 81 extends over the entire length in the width direction of the photovoltaic power generation sheet 1. The first direction D1 can be a direction in which the convex portion 32 extends.

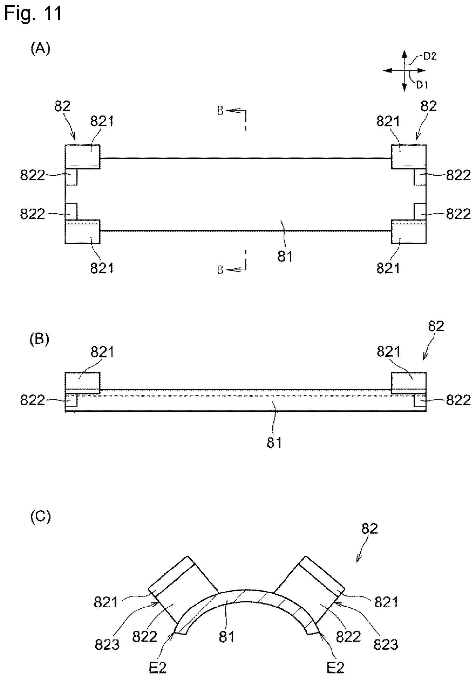

As illustrated in Fig. 11(C), the spacer 81 is formed in a curved shape in such a manner that the spacer 81 covers a corner portion in a cross section orthogonal to the first direction D1. That is, the spacer 81 is curved in such a manner that the spacer 81 protrudes upward in a cross section orthogonal to the first direction D1. The curvature radius of the upper surface of the spacer 81 is preferably larger than the curvature radius of the corner portion. The curvature radius of the upper surface of the spacer is, for example, preferably 10 mm or more, more preferably 25 mm or more, and still more preferably 40 mm or more. On the other hand, the curvature radius of the upper surface of the spacer 81 is, for example, preferably 200 mm or less, more preferably 150 mm or less, and still more preferably 100 mm or less. In this way, when the spacer 81 supports the photovoltaic power generation sheet 1, the angle at which the photovoltaic power generation sheet 1 is bent can be made smaller than the angle at which the photovoltaic power generation sheet 1 is directly supported at the corner portion, and the bending of the photovoltaic power generation sheet 1 can be reduced.

Examples of the material of the spacer 81 include synthetic resin, composite material, metal, carbon, pulp, natural rubber, and ceramic. From the viewpoint of being used outdoors, examples of the material of the spacer 81 include polypropylene, polyethylene, ABS resin, polyvinyl chloride, methacrylic resin, phenol resin, epoxy resin, polyurethane resin, melamine resin, unsaturated polyester resin, PPS, NBR, SBR and the like as long as the material of the spacer 81 is a synthetic resin. Examples of the metal include an aluminum alloy, a stainless alloy, steel, niobium, a nickel alloy, zirconium, chromium, and a titanium alloy. Here, since the spacer 81 is covered with the photovoltaic power generation sheet 1, high weather resistance is not necessarily required.

The composite material preferably contains reinforcing fibers. The material of the reinforced fibers contained in a composite reinforced material is not particularly limited, and examples thereof include glass fibers, carbon fibers, aramid fibers, and metal fibers. The content of the fibers is preferably 5% by mass or more, more preferably 15% by mass or more, and still more preferably 30% by mass or more with respect to the total mass of the spacer 81. In this way, the strength of the upper facing portion 821 can be set to an appropriate strength. From the viewpoint of enhancing the moldability, the content of the fiber is preferably 80 mass% or less, more preferably 70 mass% or less, and still more preferably 60 mass% or less with respect to the total mass of the spacer 81. The color is preferably close to black. By preventing light transmission, deterioration of the synthetic resin contained in the composite reinforced material can be reduced.

The spacer 81 may be made of one material or a plurality of composite materials. Further, the spacer 81 may be formed of one layer or a plurality of layers.

An edge E2 on the outside of the upper surface of the spacer 81 in the second direction D2 is preferably chamfered. This is because the edge E2 of the spacer 81 can come into contact with the lower surface of the photovoltaic power generation sheet 1 when the spacer 81 supports the photovoltaic power generation sheet 1. By chamfering the edge E2 of the spacer 81, the damage to the photovoltaic power generation sheet 1 can be further reduced. The chamfering may be C chamfering or R chamfering.

### Spacer attachment portion 82

The spacer attachment portion 82 attaches the spacer 81 to the photovoltaic power generation sheet 1. As illustrated in Fig. 11(A), the spacer member 8 according to the present embodiment has a pair of spacer attachment portions 82 separated in the first direction D1. Each spacer attachment portion 82 includes a plurality of upper facing portions 821 and a plurality of joint portions 822. The pair of spacer attachment portions 82 is attached to each of one end portion and the other end portion of the photovoltaic power generation sheet 1 in the first direction D1.

The upper facing portion 821 faces a surface including the light receiving surface of the photovoltaic power generation sheet 1. The upper facing portion 821 according to the present embodiment faces a portion on the upper side of the sealing edge member 19 (first bonding portion 191). As illustrated in Fig. 11(C), the upper facing portions 821 is disposed on the upper side with a space from the spacer 81, and a part of the photovoltaic power generation sheet 1 is disposed between the upper facing portion 821 and the spacer 81.

The material of the upper facing portion 821 may be the same as or different from the material of the spacer 81. Since the upper facing portion 821 is directly exposed to wind and rain, it is preferable that the upper facing portion has higher weather resistance than the spacer 81. In this case, for example, a synthetic resin, a composite material, a metal, carbon, ceramic, or the like is preferably used. In addition, in order to maintain the bent state of the photovoltaic power generation sheet 1, a composite reinforced material or metal is more preferable. The material of the reinforced fibers contained in a composite reinforced material is not particularly limited, and examples thereof include glass fibers, carbon fibers, aramid fibers, and metal fibers. The content of the fibers is preferably 5% by mass or more, more preferably 15% by mass or more, and still more preferably 30% by mass or more with respect to the total mass of the upper facing portion 821. In this way, the strength of the upper facing portion 821 can be set to an appropriate strength. From the viewpoint of enhancing the moldability, the content of the fiber is preferably 80 mass% or less, more preferably 70 mass% or less, and still more preferably 60 mass% or less with respect to the total mass of the upper facing portion 821. The color is preferably close to black. By preventing light transmission, deterioration of the synthetic resin contained in the composite reinforced material can be reduced.

The joint portion 822 faces the end surface of the photovoltaic power generation sheet 1 and connects the upper facing portion 821 and the spacer 81. The upper end portion of the joint portion 822 is connected to the lower surface of the upper facing portion 821, and the lower end portion of the joint portion 822 is connected to the upper surface of the spacer 81. A plurality of joint portions 822 are connected to the plurality of upper facing portions 821 on a one-to-one basis. The material of the joint portion 822 may be the same as or different from the material of the spacer 81 and/or the upper facing portion 821. In the present embodiment, the spacer 81, the upper facing portion 821, and the joint portion 822 are integrally formed of the same material. By integrally forming the spacer 81 and the joint portion 822, it is possible to reduce the damage of not only the back surface but also the side surface of the photovoltaic power generation sheet 1.

As illustrated in Fig. 10, the spacer 81 is preferably attached to the photovoltaic power generation sheet 1 by the spacer attachment portion 82 in such a manner that the spacer 81 can move in a direction (that is, the second direction D2) intersecting the first direction D1 in plan view. As illustrated in Fig. 11(C), the spacer attachment portion 82 has opening surfaces 823 at both ends in the second direction D2. With the end portion of the photovoltaic power generation sheet 1 in the first direction D1 passing through the opening surface 823, the spacer member 8 can move in the second direction D2 along edge portions of both ends of the photovoltaic power generation sheet 1 in the first direction D1 as illustrated in Fig. 10. The example in which the spacer member 8 moves with respect to the photovoltaic power generation sheet 1 is described here, and the photovoltaic power generation sheet 1 may move with respect to the spacer member 8, and the photovoltaic power generation sheet 1 and the spacer member 8 may move relative to each other.

The spacer attachment portion 82 according to the present embodiment moves in the second direction D2 along the edge of the photovoltaic power generation sheet 1, and for example, a rail may be provided on the photovoltaic power generation sheet 1, and the spacer attachment portion 82 may be attached to the rail portion. Examples of the rail include a guide bar, a groove, and a wire.

As described above, since the spacer 81 is attached to the photovoltaic power generation sheet 1 by the spacer attachment portion 82 in such a manner that the spacer 81 can move in the second direction D2, it is easy to finely adjust the position of the photovoltaic power generation sheet 1 after the spacer 81 is positioned at the corner portion of the roof when the photovoltaic power generation sheet 1 is installed.

### Seventh modification

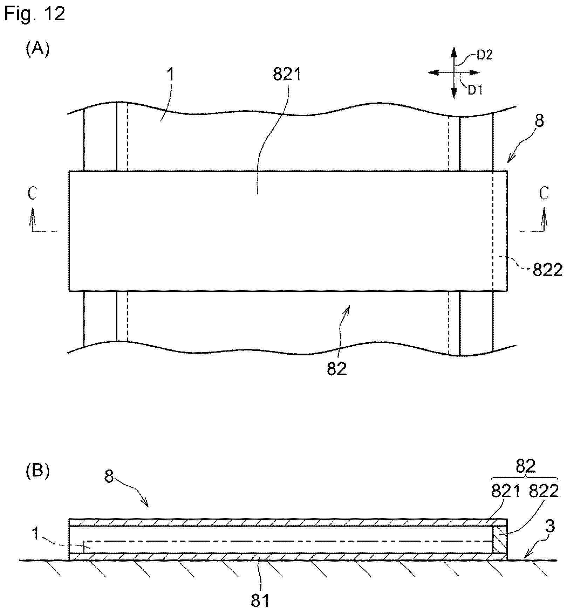

In the sixth modification, the spacer member 8 has a pair of spacer attachment portions 82 separated from each other on both sides in the first direction D1, and may have only one spacer attachment portion 82 as illustrated in Fig. 12. The spacer attachment portion 82 of the first modification includes one upper facing portion 821 facing a surface including the light receiving surface and one joint portion 822. The upper facing portion 821 extends from one end portion to the other end portion of the photovoltaic power generation sheet 1 in the first direction D1. The joint portion 822 is connected to only one end portion of the upper facing portion 821 in the first direction D1. In this way, the spacer member 8 having a simple structure can be formed, and the cost can be reduced.

### Eighth modification

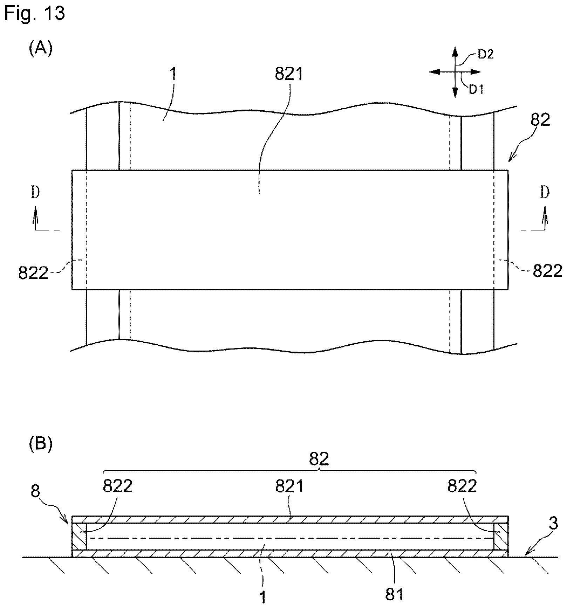

In the seventh modification, the spacer member 8 includes one joint portion 822 only at one end portion in the first direction D1 with respect to one upper facing portion 821 in one spacer attachment portion 82, and may have a structure as illustrated in Fig. 13. That is, the spacer member 8 of the present modification includes two or more joint portions 822 connected to both end portions of one upper facing portion 821 in the first direction D1. In this way, the spacer member 8 can have high strength, and a stable structure can be obtained.

### Ninth modification

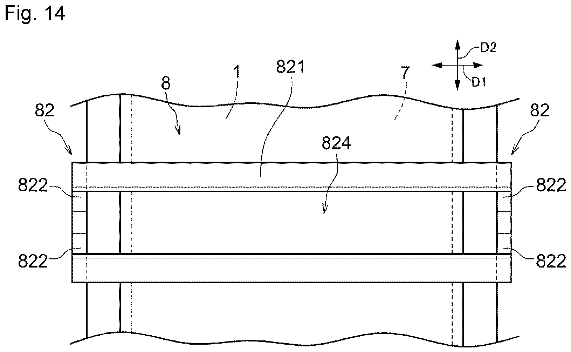

In the spacer member 8 according to the eighth modification, there is a concern that a portion of the power generator 7 overlapping the upper facing portion 821 is shaded by the upper facing portion 821 and the power generation efficiency is lowered, and for example, as illustrated in Fig. 14, an opening 824 through which sunlight passes may be formed in the upper facing portion 821. The opening 824 may be formed over the entire length in the first direction D1 in the upper facing portion 821, or may be formed in a part of the length in the first direction D1 in the upper facing portion 821. When the upper facing portion 821 is made of synthetic resin, the upper facing portion 821 may be made of a transparent material. In this way, it is possible to suppress the deterioration of the power generation efficiency of the photovoltaic power generation sheet 1 while having a stable structure.

In the ninth modification, similarly to the eighth modification, the plurality of joint portions 822 separated in the first direction D1 are provided, and similarly to the first modification, the joint portion 822 may be provided only at one end portion in the first direction D1 with respect to one upper facing portion 821.

### Tenth modification

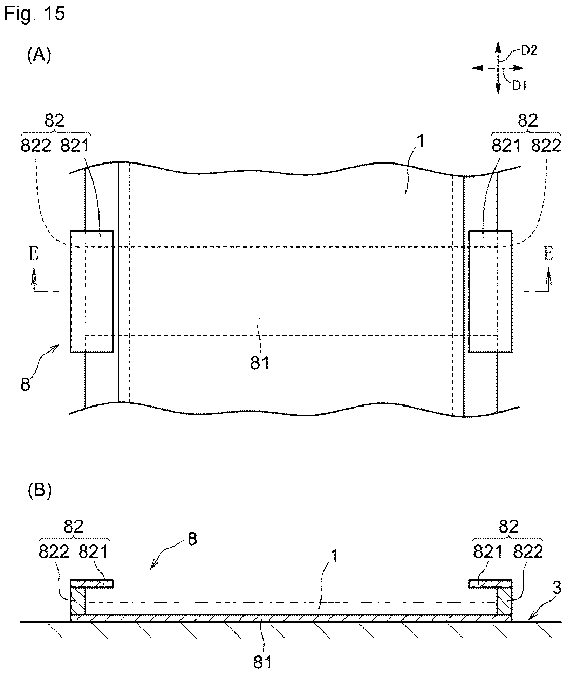

In the above embodiment, one spacer attachment portion 82 includes two upper facing portions 821, and, as illustrated in Fig. 15, each spacer attachment portion 82 may include one upper facing portion 821. In this case, in the joint portion 822, one joint portion 822 may be provided for one facing portion, or two joint portions 822 may be provided as in the sixth modification. In this way, the spacer member 8 having a simple structure can be formed, and the cost can be reduced.

### Eleventh modification

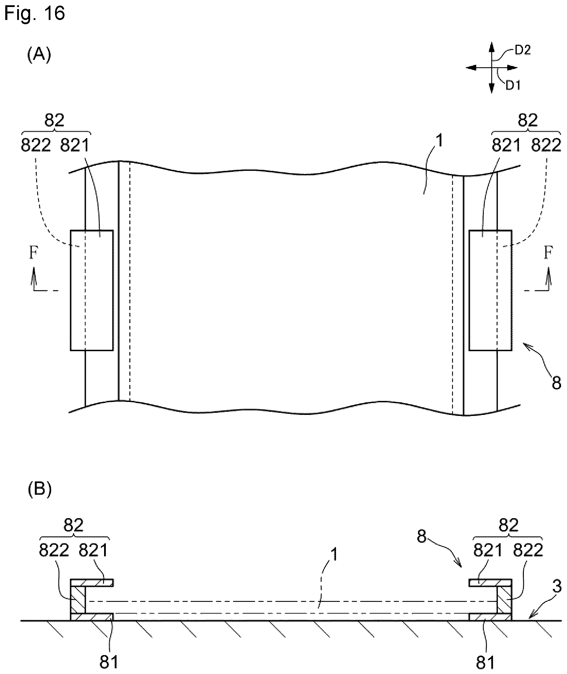

In the sixth modification, the spacer member 8 has one spacer 81 extending from one end portion to the other end portion of the photovoltaic power generation sheet 1 in the first direction D1, and as illustrated in Fig. 16, a pair of spacers 81 separated in the first direction D1 may be provided. In this case, the thickness of the spacer 81 is preferably set in consideration of the deflection amount of the photovoltaic power generation sheet 1. The photovoltaic power generation sheet 1 may be partially in contact with the corner portion of the exterior member 3, and is preferably separated from the corner portion of the exterior member 3. In this way, the ease of attachment of the spacer member 8 to the photovoltaic power generation sheet 1 can be improved while obtaining the above effect, and the cost of the spacer member 8 can be reduced.

### Twelfth modification

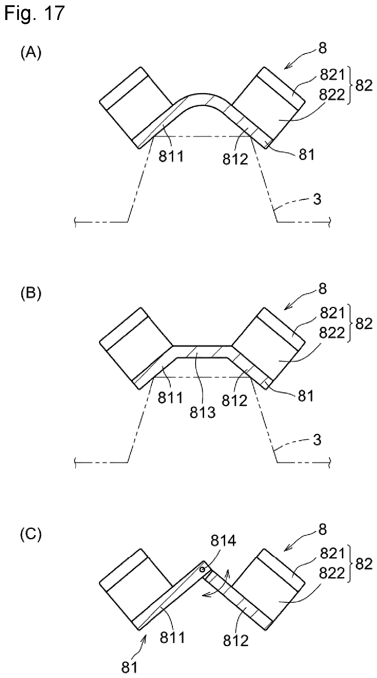

As illustrated in Fig. 17, the spacer 81 includes a spacer first portion 811 positioned on one side with respect to the corner portion of the convex portion 32 and a spacer second portion 812 positioned on the other side with respect to the corner portion in the second direction D2. The spacer second portion 812 may be movable with respect to the spacer first portion 811. As illustrated in Fig. 17(A), the spacer 81 according to one modification is configured in such a manner that the spacer second portion 812 is elastically deformable with respect to the spacer first portion 811. In the spacer 81 according to the present modification, the spacer first portion 811 and the spacer second portion 812 are directly connected. The spacer first portion 811 and the spacer second portion 812 may be connected in such a manner that the spacer first portion 811 and the spacer second portion 812 have a certain degree of angle so as to be deformed according to the size of the corner portion at the site, or may be molded in a desired shape in advance.

The flexural modulus of the spacer 81 is preferably larger than the flexural modulus of the photovoltaic power generation sheet 1. Since the spacer 81 receives an external force from the photovoltaic power generation sheet 1 when supporting the photovoltaic power generation sheet 1, when the flexural modulus is small, the spacer 81 can be deformed to a curvature radius close to the curvature radius of the corner portion.

The flexural strength of the spacer 81 is not particularly limited, and is preferably 1.05 times or more and 5 times or less, more preferably 1.25 times or more and 3 times or less, and still more preferably 1.5 times or more and 2 times or less the bending strength of the photovoltaic power generation sheet 1. The flexural strength of the spacer 81 is preferably 15 MPa or more and 250 MPa or less, more preferably 25 MPa or more and 230 MPa or less, and still more preferably 50 MPa or more and 210 MPa or less. In this way, it is possible to suppress the deformation of the spacer 81 while reducing the damage to the spacer 81 with respect to the photovoltaic power generation sheet 1.

As illustrated in Fig. 17(B), the spacer first portion 811 and the spacer second portion 812 may be connected by a connection portion 813 having a flat plate-shape. The spacer first portion 811 is elastically deformably connected to the connection portion 813. The spacer second portion 812 is elastically deformably connected to the connection portion 813. That is, the spacer second portion 812 is movable with respect to the spacer first portion 811. Portions to be connected of the spacer first portion 811 and the connection portion 813 and portions to be connected of the spacer second portion 812 and the connection portion 813 are connected to be rigid, and only the connection portion 813 may be made of a deformable material.

As illustrated in Fig. 17(C), the spacer first portion 811 and the spacer second portion 812 may be connected by a rotation shaft 814. The rotation shaft 814 is parallel to the first direction D1. That is, the spacer second portion 812 is movable with respect to the spacer first portion 811.

### Modifications of sixth modification to twelfth modification

In the sixth modification, the spacer member 8 is movably attached to the photovoltaic power generation sheet 1, and may be fixed to the photovoltaic power generation sheet 1. The spacer attachment portion 82 may include, for example, a bonding layer, an adhesive layer, a screw, a pin, a rivet, or the like. Further, after the position of the spacer member 8 with respect to the photovoltaic power generation sheet 1 is determined, the spacer member 8 may be fixed to the photovoltaic power generation sheet 1. Examples of a method for fixing the spacer member 8 to the photovoltaic power generation sheet 1 include a bonding layer, an adhesive layer, a screw, a pin, and a rivet.

### Thirteenth modification

The fixing member 5 according to the above embodiment may be, for example, a flange member having a flange portion such as a bolt, a sandwiching member, or the like. Examples of the sandwiching member include a clamp and a vise. The photovoltaic power generation sheet 1 can be detachably fixed to the exterior member 3 by a peripheral edge portion of the photovoltaic power generation sheet 1 in a plan view (when the photovoltaic power generation sheet 1 is viewed in the normal direction), in other words, by a flange member or a sandwiching member disposed in a portion other than the power generator 7. The flange member or the sandwiching member may be fixed to the peripheral edge portion in a part the of length or over the entire length. In addition, in a case where a plurality of flange members or sandwiching members are used, they may be arranged at a constant pitch or may be arranged at an unequal pitch.

### Fourteenth modification

As still another example of the fixing member 5, for example, a hanging member such as a hook, a lock, or an L-shaped hook may be provided on the exterior member 3. The photovoltaic power generation sheet 1 can be detachably fixed to the exterior member 3 by penetrating a hanging member at the peripheral edge portion of the photovoltaic power generation sheet 1 in plan view, that is, at a portion other than the power generator 7. A fixing hole through which the hanging member passes may be formed in advance in the photovoltaic power generation sheet 1, or a fixing hole may be formed by pressing the photovoltaic power generation sheet 1 against the hanging member at the time of construction.

In a case where a fixing hole is formed in the photovoltaic power generation sheet 1 in advance, the inside of the fixing hole and the peripheral edge portion of the fixing hole may be covered with metal, resin, or the like. As a result, when the photovoltaic power generation sheet 1 is installed, it is possible to suppress cracking and breakage from the fixing hole due to strong wind, vibration, or the like.

The hanging member has at least a convex portion protruding from the photovoltaic power generation sheet 1. The height of the convex portion with respect to the exterior member 3 may be longer than the thickness of the photovoltaic power generation sheet 1. The height of the convex portion may be 2 times or more, preferably 5 times or more, and more preferably 10 times or more the thickness of the photovoltaic power generation sheet 1. With such a configuration, the fixing force of the photovoltaic power generation sheet 1 can be increased. The height of the convex portion is preferably 100 times or less, more preferably 50 times or less, and still more preferably 50 times or less the thickness of the photovoltaic power generation sheet 1. With such a configuration, the convex portion becomes inconspicuous after installation, and thus the appearance after construction is excellent. The shape of the convex portion of the hanging member is not particularly defined, and the cross-sectional shape thereof is also not particularly defined.

With such a hanging member, the photovoltaic power generation sheet 1 can be easily installed on the exterior member 3, breakage of the cell can be suppressed at the time of detachment, and a higher fixing force can be applied.

### Fifteenth modification

As still another example of the fixing member 5, for example, a frame member such as a frame, a rail, or a frame may be used. The photovoltaic power generation sheet 1 can be detachably fixed by pressing the photovoltaic power generation sheet 1 against the exterior member 3 with the frame member at the peripheral edge portion of the photovoltaic power generation sheet 1 in plan view, that is, at a portion other than the power generator 7.

The frame member may be configured to slide with respect to the photovoltaic power generation sheet 1 at the time of attachment. For example, a U-shaped frame member is slid and attached along the longitudinal direction of the photovoltaic power generation sheet 1, and then the frame member of the remaining one side is attached. Thus, the photovoltaic power generation sheet 1 can be easily installed on the exterior member 3.

The materials of the flange member, the sandwiching member, the hanging member, and the frame member described above are not particularly limited, and may be, for example, metal, resin, composite reinforced material, or the like. Examples of the metal include aluminum, SUS, and a coated metal member. Examples of the resin include polypropylene, polyethylene, hard vinyl chloride, polycarbonate, polyamide, and PPS. Examples of the composite reinforced material include those containing the resin, carbon, glass, and metal fibers.

The flange member, the sandwiching member, the hanging member, and the frame member are fixed to the exterior member 3. The fixing method to the exterior member 3 is not particularly limited, and examples thereof include bonding, sandwiching, bolt/nut, pinning, welding, welding, and screwing to an installation surface.

### Second embodiment

A conventional solar panel installation structure includes a reinforcing member and a fixing member fixed to a surface of a roof with a bonder or the like. One end portion of the solar panel is rotatably attached to a fixing member via a hinge, and the other end portion of the solar panel is detachably fixed to a reinforcing member formed of a magnetic material via a magnet. Thereby, the solar panel is installed on the roof.

A conventional solar panel is a rigid solar cell processed into a plate shape, and is generally installed on a roof using an attachment frame such as a fixing member or a reinforcing member. However, the attachment frame has a complicated structure and is heavy. For this reason, when the conventional solar panel is installed, the work of attaching the attachment frame requires a great effort.

In recent years, photovoltaic power generation sheets using organic solar cells such as perovskite compounds have been widely used. The power generator of this type of photovoltaic power generation sheet has a plurality of belt-shaped power generation cells arranged in the width direction, and is monolithic.

Since the photovoltaic power generation sheet is flexible, when there is a gap between the photovoltaic power generation sheet and the installation surface or when the photovoltaic power generation sheet is only partially fixed, flutter is likely to occur due to the influence of wind or the like under the installed state. In particular, since the photovoltaic power generation sheet being flexible is lightweight, many of the photovoltaic power generation sheets are increased in size, and it has become clear in recent years that the above problems are more remarkable. Since the photovoltaic power generation sheet has a feature that the power generation efficiency is decreased by vibration, flutter needs to be suppressed as much as possible.

Here, as a method of directly installing the photovoltaic power generation sheet on the surface of the roof, it is conceivable that the entire region of the photovoltaic power generation sheet is fixed to the surface of the roof, or the peripheral edge portion of the photovoltaic power generation sheet is fixed to the surface of the roof over the entire circumference. However, in this method, in a case where the photovoltaic power generation sheet needs to be collected, the power generator of the photovoltaic power generation sheet being flexible is likely to be bent when the photovoltaic power generation sheet is removed from the surface of the roof. In this case, stress may concentrate on the power generator, and the power generator may be broken. Furthermore, in a case of fixing a large-sized photovoltaic power generation sheet, it is necessary to more firmly fix the photovoltaic power generation sheet as compared with a case of fixing a solar cell of a conventional size, and thus breakage is more likely to occur when the photovoltaic power generation sheet is collected.

On the other hand, it is also conceivable to cover the entire outer periphery of the photovoltaic power generation sheet with a frame-shaped frame member. However, when the entire outer periphery of the photovoltaic power generation sheet is covered with the frame-shaped frame member, the power generation cells at both ends of the plurality of power generation cells arranged in the width direction are covered over the entire length in the longitudinal direction. There is a problem in this type of photovoltaic power generation sheet that, even when only one of the plurality of power generation cells is covered over the entire length in the longitudinal direction, the power generation efficiency is extremely decreased. Further, there is a problem that, since only the outer periphery of the photovoltaic power generation sheet is fixed, a sufficient fixing force cannot be obtained.

Therefore, an object of the installation structure according to the present embodiment is to provide an installation structure in which a decrease in power generation efficiency is suppressed. Hereinafter, an example of the installation structure 100 of the photovoltaic power generation sheet 1 according to the present embodiment will be described.

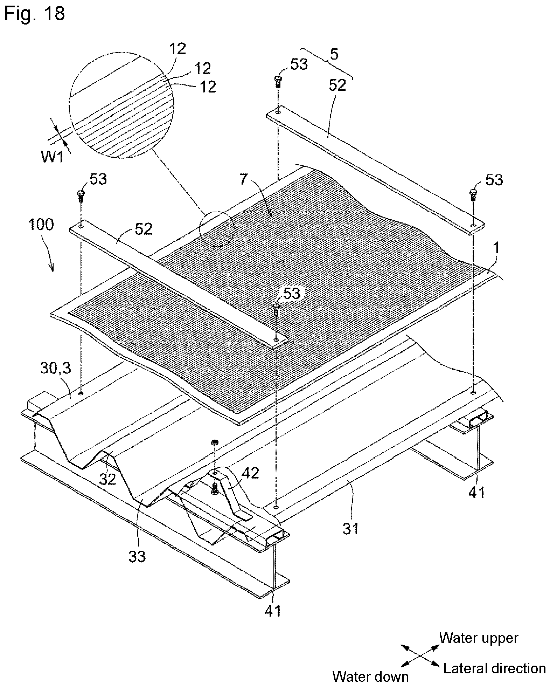

As illustrated in Fig. 18, the installation structure 100 of the photovoltaic power generation sheet 1 according to the present embodiment includes the photovoltaic power generation sheet 1 and an attachment member 52 for attaching the photovoltaic power generation sheet 1 to the installation surface 30. The photovoltaic power generation sheet 1 is a sheet material that generates power by receiving sunlight. The photovoltaic power generation sheet 1 includes one or a plurality of power generators 7. As illustrated in Fig. 18, the power generator 7 is monolithic in a state where belt-shaped power generation cells 12 extending in one direction are arranged side by side in the width direction of the power generation cells 12. In the present disclosure, a monolithic structure may be referred to as a "monolithic structure".

Each of the attachment members 52 is formed in an elongated shape extending in one direction. The attachment member 52 is fixed to the installation surface 30, and the photovoltaic power generation sheet 1 can be attached to the installation surface 30 by pressing the photovoltaic power generation sheet 1 from above. Under a state where the photovoltaic power generation sheet 1 and the attachment member 52 are attached to the installation surface 30, the longitudinal direction of the attachment member 52 intersects the longitudinal direction of the power generation cell 12 of the photovoltaic power generation sheet 1.

In the installation structure 100 of the photovoltaic power generation sheet 1 configured as described above, only a part of the entire length of the belt-shaped power generation cell 12 is covered with the attachment member 52, and thus, it is possible to reduce a decrease in power generation efficiency in each power generation cell 12. Moreover, since the photovoltaic power generation sheet 1 can be pressed by the long attachment member 52, flutter can be suppressed. Further, since the photovoltaic power generation sheet 1 is installed by being pressed from above by the attachment member 52 without being bonded to the installation surface 30, it is also possible to reduce bending when being detached from the installation surface 30. As a result, according to the installation structure 100 of the photovoltaic power generation sheet 1 according to the present embodiment, stable power generation efficiency can be obtained.

The installation surface 30 in the present embodiment refers to a surface including a portion to which the photovoltaic power generation sheet 1 is attached. Examples of the location including the installation surface 30 include a roof, a wall member, a floor member, a road, a cover such as a precipitation basin, a vinyl house, an automobile, an aircraft, a cargo bed of a truck, a ship, and the like. The exterior member 3 in the first embodiment and the first modification to the fifteenth modification is the installation surface 30 of the present embodiment.

In the present embodiment, the installation surface 30 will be described as a roof surface having a gradient. On the roof surface, a direction along the gradient is defined as a "water flow direction", and a direction intersecting the water flow direction is defined as a "lateral direction". In the present embodiment, the "lateral direction" is orthogonal to the water flow direction. A direction orthogonal to the water flow direction and the lateral direction is defined as a "up-and-down direction". In the water flow direction, a high side is defined as "water upper side", and a low side is defined as "water down side".

In the present embodiment, "plan view" refers to an object being viewed along the up-and-down direction. In the present embodiment, "parallel" includes not only a case where two straight lines, sides, surfaces, and the like do not intersect even when extended, but also a case where an angle formed by the two straight lines, sides, surfaces, and the like intersects within a range of 10°. In addition, "orthogonal" includes a case where two straight lines, sides, surfaces, and the like intersect at 90° ± 10°.

Hereinafter, details of the installation structure 100 of the photovoltaic power generation sheet 1 according to the present embodiment will be described in detail with reference to the drawings. However, since the configuration of the photovoltaic power generation sheet 1 of the present embodiment is the same as that of the photovoltaic power generation sheet 1 of the first embodiment, redundant description will be omitted. In addition, each element of the second embodiment can be applied to the first embodiment, or can be implemented only in the second embodiment without being affected by the first embodiment.

As illustrated in Fig. 18, each power generation cell 12 of the photovoltaic power generation sheet 1 of the present embodiment extends in one direction and is formed in a band shape. In the present embodiment, the longitudinal direction of the power generation cell 12 is parallel to the longitudinal direction of the photovoltaic power generation sheet 1. One power generation cell 12 extends from an end portion on one side (one end portion) to an end portion on the other side (the other end portion) of the photovoltaic power generation sheet 1 in the longitudinal direction. The maximum distance from the end surface of the back sheet 11 to the end surface of the power generation cell 12 is preferably 1.0 mm or more and 500 mm or less, more preferably 2.0 mm or more and 300 mm or less, and still more preferably 3.0 mm or more and 100 mm or less. A case where the maximum distance from the end surface of the back sheet 11 to the end surface of the power generation cell 12 is 500 mm or less is referred to as the "end portion of the photovoltaic power generation sheet 1". In the present embodiment, as illustrated in Fig. 2(A), the sealing layer 18 is present between the end surface of the back sheet 11 and the end surface of the power generation cell 12, and the end surface of the power generation cell 12 may be flush with the end surface of the back sheet 11 and/or the end surface of the barrier sheet 17.

The width of the power generation cell 12 is preferably 0.003% or more and 1.0% or less, more preferably 0.01% or more and 0.3% or less, and still more preferably 0.03% or more and 0.15% or less with respect to the length of the power generation cell 12. Specifically, the width W1 of the power generation cell 12 is preferably 1 mm or more and 10 mm or less, more preferably 1.5 mm or more and 7 mm or less, and still more preferably 2 mm or more and 5 mm or less.

### Installation structure 100

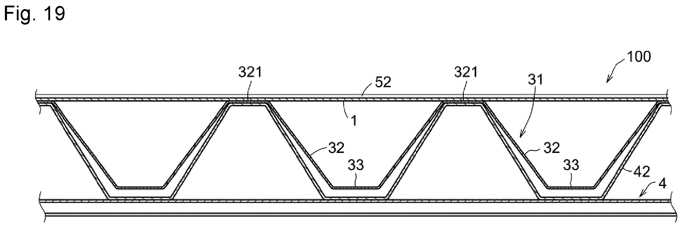

As in the first embodiment, the photovoltaic power generation sheet 1 may be attached to the installation surface 30 in a state of being deformed along the installation surface 30, or may be attached to the roof surface in a planar shape. Here, an example of being attached to the roof surface in a planar shape will be described. As illustrated in Fig. 19, the photovoltaic power generation sheet 1 is disposed across the top portions 321 of the plurality of convex portions 32, and is attached to the roof surface by the fixing member 5. The fixing member 5 includes a plurality of attachment members 52 and a fixture 53. The photovoltaic power generation sheet 1 is fixed by being pressed against the roof surface by a plurality of attachment members 52 from above. In the present embodiment, as illustrated in Fig. 4, the photovoltaic power generation sheet 1 is disposed in such a manner that the longitudinal direction of the power generation cell 12 is parallel to the water flow direction.

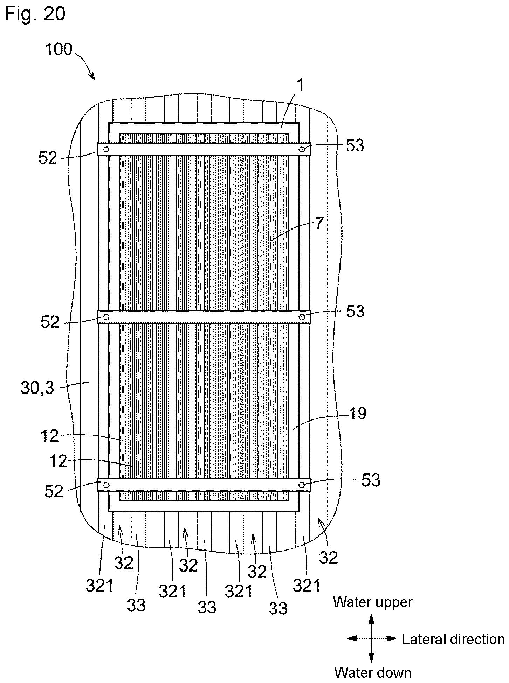

Each attachment member 52 is disposed in such a manner that the longitudinal direction thereof intersects the longitudinal direction of the power generation cell 12. In the present embodiment, the longitudinal direction of each attachment member 52 is orthogonal to the longitudinal direction of the power generation cell 12, that is, parallel to the lateral direction. As illustrated in Fig. 20, the attachment members 52 overlap the power generator 7 in a state where the photovoltaic power generation sheet 1 is pressed against the roof surface. As described above, in the present embodiment, even when attachment members 52 overlap the power generator 7, all portions of each power generation cell 12 are not covered by the attachment members 52. As a result, when the power generator 7 having a monolithic structure having the belt-shaped power generation cell 12 is attached to the installation surface 30 by the attachment members 52, it is possible to simplify the installation structure while suppressing a decrease in power generation efficiency.

The plurality of attachment members 52 is disposed at intervals in the water flow direction. It is preferable that two of the plurality of attachment members 52 press an end portion of the photovoltaic power generation sheet 1 in the longitudinal direction. Further, the other attachment members 52 among the plurality of attachment members 52 are preferably disposed between the attachment members 52 which press the end portion of the photovoltaic power generation sheet 1. As a result, it is possible to suppress fluttering of the photovoltaic power generation sheet 1 due to the wind, to suppress a decrease in power generation efficiency, and to reduce breakage.

Each of the attachment members 52 is formed in an elongated shape extending in one direction. In the present embodiment, each of the attachment members 52 is formed in a flat plate shape. The width of each of the attachment members 52 is preferably constant in the longitudinal direction. The width of each of the attachment members 52 is preferably 2 mm or more and 50 mm or less, more preferably 3 mm or more and 40 mm or less, and still more preferably 5 mm or more and 35 mm or less. By setting the width of each of the attachment members 52 to 2 mm or more, bending of the power generator 7 can be suppressed, and breakage of the power generator 7 can be reduced. By setting the width of each of the attachment members 52 to 50 mm or less, the area can be reduced where the power generator 7 is covered by the attachment member 52, and the power generation efficiency can be increased.

The thickness of the attachment member 52 is preferably thin. The thickness of the attachment member 52 is preferably 1 mm or more and 20 mm or less, more preferably 2 mm or more and 15 mm or less, and still more preferably 3 mm or more and 10 mm or less. Thus, the shadow of the attachment member 52 overlapping the power generator 7 can be reduced.

The attachment member 52 is formed to be longer than the length of the photovoltaic power generation sheet 1 in the shortitudinal direction. As illustrated in Fig. 18, the attachment member 52 is disposed in such a manner that the longitudinal direction of the attachment member 52 is along the lateral direction, and the attachment member 52 is attached to the upper surfaces of the top portions 321 of the plurality of convex portions 32 in such a manner that the attachment member 52 is across the plurality of convex portions 32. In the attachment member 52, the portion protruding from the edge of the photovoltaic power generation sheet 1 is fixed to the installation surface 30 by the fixture 53, whereby the attachment member 52 is fixed to the installation surface 30. The fixture 53 is included in the fixing member 5. Examples of the fixture 53 used in the present embodiment include a bolt/nut, a screw, a rivet, a pin, a hook and loop fastener, a line fastener, and a double-sided tape. The fixing of the attachment member 52 to the roof surface is not limited to the fixture 53, and may be, for example, bonding, welding, magnetic bonding, or the like.

The attachment member 52 is preferably formed in a flat plate shape. As a result, the contact area with respect to the photovoltaic power generation sheet 1 can be increased. An anti-slip sheet is preferably disposed on a contact surface of the attachment member 52 with respect to the photovoltaic power generation sheet 1.

On the contact surface of the flat plate of the attachment member 52, a corner portion (edge) in contact with the photovoltaic power generation sheet 1 is preferably subjected to C chamfering or R chamfering. As a result, when an external force is applied in the vertical direction from the installation surface 30 at the contact portion between the photovoltaic power generation sheet 1 and the attachment member 52 due to wind or the like, it is possible to suppress concentration of the force applied from the attachment member 52 to the photovoltaic power generation sheet 1, and it is possible to effectively suppress breakage of the photovoltaic power generation sheet 1. In particular, unlike a rigid photovoltaic power generator, it is difficult to predict the deformation of the photovoltaic power generation sheet 1 which is likely to be elastically deformed, and therefore, the photovoltaic power generation sheet 1 can be installed for a long period of time by dispersing a local force applied to the contact portion. A similar method is to provide a spacer of elastic member or the like between the photovoltaic power generation sheets 1. The elastic member is not particularly limited, and examples thereof include rubber, a soft resin, a metal washer, a torsion coil spring, and a leaf spring.

However, the attachment member 52 is not limited to a flat plate shape, and may be formed in, for example, a rod shape having a rectangular cross section, a rod shape having a circular cross section, a pipe shape, or a semicircular cross section in which only the contact surface with the photovoltaic power generation sheet 1 is a flat surface. The attachment member 52 of the present embodiment is formed in a linear shape, but as long as the longitudinal direction of the attachment member 52 intersects the longitudinal direction of power generation cell 12, for example, a shape such as a V shape in plan view, a Y shape in plan view, a Z shape in plan view, and an S shape in plan view may be adopted.

The material of the attachment member 52 is not particularly limited, and examples thereof include metal, synthetic resin, carbon, rubber, cloth, leather, and the like. Examples of the metal include aluminum, SUS, and a coated metal member. Examples of the synthetic resin include thermoplastic resins, thermosetting resins, general-purpose plastics, composite reinforced materials (engineering plastics), and vinyl resins (for example, polyvinyl chloride). Specific examples of the synthetic resin include polypropylene, polyethylene, hard vinyl chloride, polycarbonate, polyamide, and PPS. Examples of the composite reinforced material include those containing the above-described synthetic resin, carbon, glass, and metal fibers.

The gap between the installation surface 30 and the photovoltaic power generation sheet 1 is preferably as small as possible from the viewpoint of more effectively suppressing the vibration of the photovoltaic power generation sheet 1. It is preferable that the gap between the photovoltaic power generation sheet 1 and one of the inclined surfaces of the valley portion 33 and the convex portion 32 is closed using a face door member or the like. In addition, a gap between the top portion 321 of the convex portion 32 and the photovoltaic power generation sheet 1 is preferably filled with a joint material. Examples of the joint material include a high-viscosity resin and cement. The viscosity of the joint material is preferably 0.1 Pa·s or more, more preferably 10 Pa·s or more. On the other hand, the viscosity of the joint material is preferably 10,000 Pa·s or less, and more preferably 1000 Pa·s or less. By setting the viscosity of the joint material to 0.1 Pa·s or more, the shape can be maintained not only in the surface direction but also in the vertical direction, so that the gap can be effectively prevented. In addition, by setting the viscosity of the joint material to 10,000 Pa · s or less, it is possible to easily spread the joint material when the joint material is applied to the installation surface 30 or the back surface of the photovoltaic power generation sheet 1 at the time of fixing the photovoltaic power generation sheet 1, and thus, it is possible to improve construction.

When the gap between the photovoltaic power generation sheet 1 and the installation surface 30 is closed, the effect of suppressing vibration by wind or the like can be obtained even when only the peripheral portion of the photovoltaic power generation sheet 1 is closed. The term "peripheral portion" as used herein refers to a region up to a certain distance from the end portion toward the central portion of the photovoltaic power generation sheet 1 in the direction along the installation surface 30. The certain distance is preferably 5 mm or more, more preferably 100 mm or more, and still more preferably 150 mm or more. On the other hand, the certain distance is preferably 250 mm or less, more preferably 200 mm or less, and still more preferably 175 mm or less. By closing the gap between the photovoltaic power generation sheet 1 and the installation surface 30 in the peripheral portion, the vibration of the photovoltaic power generation sheet 1 can be appropriately suppressed, the joint material can be efficiently used, and the weight load on the installation surface 30 and the like can be reduced, so that the photovoltaic power generation sheet 1 can be installed on the installation surface such as a fragile roof.

In a case where only the peripheral portion of the photovoltaic power generation sheet 1 is closed, a cavity closed to the outside with relatively high airtightness is generated between the photovoltaic power generation sheet 1 and the installation surface 30. Therefore, the air in the cavity expands and contracts due to a temperature change, which may generate stress in a direction perpendicular to the photovoltaic power generation sheet 1, and may cause breakage of the photovoltaic power generation sheet 1.

In order to suppress this phenomenon, the photovoltaic power generation sheet 1 can be more stably installed by making the joint material porous or providing an air hole in the joint material. The total passage cross-sectional area of the air hole is preferably 20mm² or more, more preferably 25mm² or more, and still more preferably 50mm² or more. On the other hand, the total passage cross-sectional area of the air hole is preferably 200mm² or less, more preferably 150mm² or less, and still more preferably 100mm² or less. By setting the air hole in such a manner that the total passage cross-sectional area is 20mm² or more, the air expanded and contracted by the temperature change and the external air can be appropriately exchanged, and the stress generated in the photovoltaic power generation sheet 1 can be reduced. In addition, by setting the air hole in such a manner that the total passage cross-sectional area is 200mm² or less, rainwater can be suppressed from entering, and deterioration of the photovoltaic power generation sheet 1 due to rainwater can be suppressed. From the viewpoint of waterproofing, the air hole is preferably provided on the lower side in the gradient direction of the installation surface 30, and more preferably faces the lower side in the gradient direction of the installation surface 30.

In a case where the gap between the outer peripheral portion of the photovoltaic power generation sheet 1 and the installation surface 30 is large and embedding with the joint material is difficult, for example, a lid member such as hard resin, metal, or ceramic may be provided at the end portion.

### Effects of second embodiment

As described above, in the installation structure 100 of the photovoltaic power generation sheet 1 according to the present embodiment, the long attachment member 52 overlaps the power generator 7, and the longitudinal direction of the attachment member 52 intersects the longitudinal direction of the power generation cell 12. Therefore, even when the attachment member 52 overlaps the power generator 7, all portions of each power generation cell 12 are not covered by the attachment member 52. Therefore, when the photovoltaic power generation sheet 1 including the power generator 7 having the belt-shaped power generation cell 12 is attached to the installation surface 30 by the attachment member 52, a simplified installation structure 100 can be realized while suppressing a decrease in power generation efficiency. In particular, a solar cell using an organic compound such as a perovskite compound has a property that a decrease in power generation efficiency is limited even when a part of the power generation cell 12 in the longitudinal direction is covered, as compared with a solar cell using an inorganic compound. Therefore, according to the installation structure 100 of the photovoltaic power generation sheet 1 according to the present embodiment, it is possible to further suppress a decrease in power generation efficiency when the photovoltaic power generation sheet 1 is attached to the installation surface 30 by the attachment member 52.

In addition, the installation surface 30 is a roof surface having a gradient. The photovoltaic power generation sheet 1 is disposed in such a manner that the longitudinal direction of the power generation cell 12 is along the water flow direction of the roof surface. Therefore, when the photovoltaic power generation sheet 1 is carried to the roof surface in a state of being wound in the longitudinal direction and installed on the roof surface, the photovoltaic power generation sheet 1 can be expanded along the gradient, and workability is excellent.

### Modifications

Hereinafter, modifications of the second embodiment will be listed. Modifications described below can be appropriately combined and applied.

### Sixteenth modification

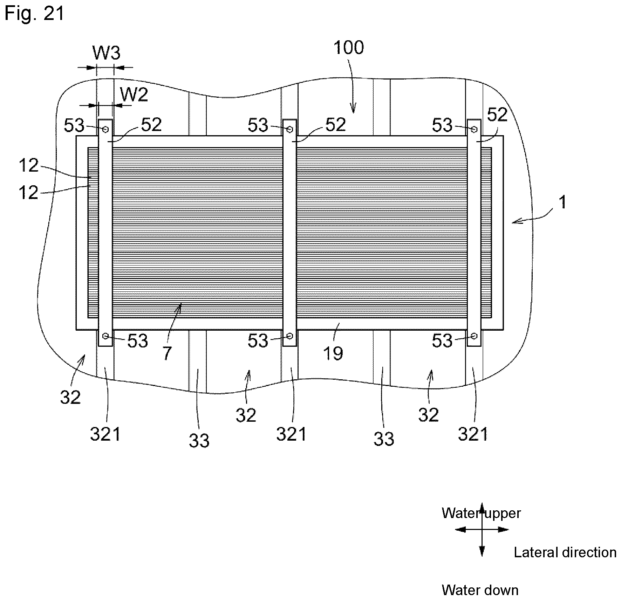

In the second embodiment, the photovoltaic power generation sheet 1 is disposed in such a manner that the longitudinal direction of the power generation cell 12 is parallel to the water flow direction. As illustrated in Fig. 21, the photovoltaic power generation sheet 1 may be disposed in such a manner that the longitudinal direction of the power generation cell 12 is parallel to the lateral direction. The photovoltaic power generation sheet 1 is disposed in such a manner that the photovoltaic power generation sheet 1 is across the plurality of convex portions 32 in the lateral direction.

The attachment member 52 is fixed to the exterior member 3 in such a manner that the longitudinal direction of the attachment member 52 is parallel to the water flow direction. The attachment member 52 is fixed to the top portion 321 of one convex portion 32 along the extending direction of the convex portion 32. Thus, the photovoltaic power generation sheet 1 contacts the attachment member 52 over the entire length in the water flow direction. As a result, the attachment member 52 can attach the photovoltaic power generation sheet 1 to the roof surface by pressing the end portion in the longitudinal direction of the photovoltaic power generation sheet 1 against the roof surface. The width W2 of the attachment member 52 is preferably equal to or less than the width W3 of the top portion 321 of the convex portion 32.

As described above, when the photovoltaic power generation sheet 1 is disposed in such a manner that the longitudinal direction of the power generation cell 12 is parallel to the lateral direction, the entire power generation cell 12 is not covered with streaky dirt even when streaky dirt occurs on the light receiving surface of the photovoltaic power generation sheet 1 along the water flow direction. As a result, even when streaky dirt is formed on the light receiving surface of the photovoltaic power generation sheet 1 along the water flow direction, it is possible to reduce a decrease in power generation efficiency.

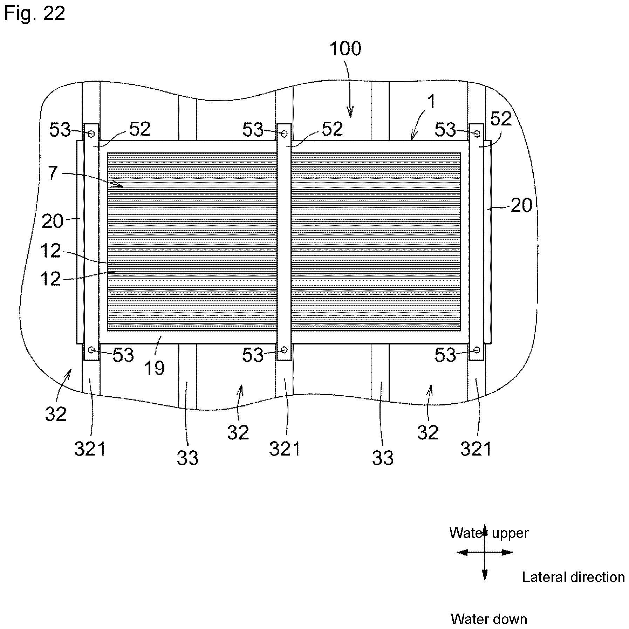

In the sixteenth modification and the second embodiment, all the attachment members 52 overlap the power generator 7, and at least one attachment member 52 may be disposed in such a manner that the attachment member 52 overlaps the power generator 7. For example, as illustrated in Fig. 22, a region 20 in which the power generator 7 is not provided may be provided at both end portions of the photovoltaic power generation sheet 1 in the longitudinal direction, and the region may be fixed by the attachment member 52.

### Other modifications

In a case of the photovoltaic power generation sheet 1 having the photoelectric conversion layer 152 containing a perovskite compound, the power generator 7 is not limited to a rectangular shape, and can be easily designed. By taking advantage of this characteristic, the shape of the photovoltaic power generation sheet 1 can be adapted to the shape of the installation surface 30. In the above embodiment, the photovoltaic power generation sheet 1 has a rectangular shape in plan view, and for example, in a case where the installation surface 30 has a fan shape in plan view, the photovoltaic power generation sheet 1 may also be formed in a fan shape in plan view. In this case, the longitudinal direction of the attachment member 52 may intersect the longitudinal direction of the power generation cell 12. The shape of the photovoltaic power generation sheet 1 is not limited to a fan shape, and examples thereof include a circular shape, an elliptical shape, and a polygonal shape.

The shortest distance between the end portion of the photovoltaic power generation sheet 1 and the power generator 7 is preferably 50 mm or less, more preferably 35 mm or less, and still more preferably 25 mm or less. In this manner, the power generation efficiency can be improved by making the area of the power generator 7 as large as possible. In addition, by setting the shortest distance between the end portion of the photovoltaic power generation sheet 1 and the power generator 7 to 5 mm or more, more preferably 10 mm or more, and still more preferably 15 mm or more, the water resistance when the photovoltaic power generation sheet 1 is used outdoors can be improved.

A rod-shaped core member may be attached to the end portion of the photovoltaic power generation sheet 1. The rod-shaped core member is preferably fixed to the end portion of the photovoltaic power generation sheet 1 in such a manner that the central axis thereof is parallel to the shortitudinal direction of the photovoltaic power generation sheet 1. When the rod-shaped core member is rotated around the central axis, the photovoltaic power generation sheet 1 is wound around the rod-shaped core member. Therefore, the photovoltaic power generation sheet 4 is not a sheet shape but a rod shape at the time of transportation, and the transportability can be improved. Further, by winding the photovoltaic power generation sheet 1 around the rod-shaped core member even after installation, the photovoltaic power generation sheet 1 can be temporarily removed from the installation surface 30 in an easy manner, and reinstallation can be facilitated. As a result, the photovoltaic power generation sheet 1 can be temporarily removed and stored in a bad weather such as a storm. The shape of the rod-shaped core member is not particularly limited as long as the rod-shaped core member can be wound with the photovoltaic power generation sheet 1, and the rod-shaped core member may be either hollow or solid, and the cross-sectional shape may be circular or polygonal. In addition, a handle may be provided on the rod-shaped core member, and the rod-shaped core member may be rotated by the handle. In addition, the power of the motor may be transmitted to the rod-shaped core member, and the rod-shaped core member may be rotated by the motor.

The winding diameter of the rod-shaped core member is preferably 5 cm or more, more preferably 7.5 cm or more, and still more preferably 10 cm or more. On the other hand, the winding diameter of the rod-shaped core member is preferably 30 cm or less, more preferably 20 cm or less, and still more preferably 15 cm or less. By setting the winding diameter of the rod-shaped core member to 5 cm or more, breakage of the photovoltaic power generation sheet 1 can be suppressed. By setting the winding diameter of the rod-shaped core member to 30 cm or less, transportation and construction can be easily performed.

In the embodiment described above, the back sheet 11 of the photovoltaic power generation sheet 1 is directly fixed to the installation surface 30, and another sheet member may be interposed between the back sheet 11 and the installation surface 30. Examples of the sheet member include a synthetic resin sheet, a fiber-reinforced resin sheet, and an elastic sheet such as rubber. Thus, the photovoltaic power generation sheet 1 can be prevented from being displaced.

The sheet member is detachably attached to the installation surface 30. Thus, the photovoltaic power generation sheet 1 is detachably fixed to the installation surface 30. As a fixing structure between the sheet member and the installation surface 30, at least one selected from the group consisting of a hook-and-loop fastener, a magnet, a double-sided tape, a bonder, a flange member, a sandwiching member, a hanging member, and a frame member described above is used.

In the above embodiment, substantially all of attachment members 52 overlap the power generator 7. However, as long as the longitudinal direction of the attachment members 52 intersects the longitudinal direction of the power generation cell 12, the present disclosure also includes attachment members 52 that only partially overlap the power generator 7.

In the above embodiment, the installation structure 100 in which the photovoltaic power generation sheet 1 is installed on the roof surface has been described, but the installation surface 30 is not limited to the roof surface, and can be applied to, for example, a wall member (metal-based siding material, ceramic-based siding material, sandwich panel, and the like), a partition, a door member, a fence member, and the like.

In the above embodiment, the photovoltaic power generation sheet 1 is installed to have a planar shape along a virtual plane including the top portion 321 of the convex portion 32 of the uneven roof 31. However, as in the first embodiment, the photovoltaic power generation sheet 1 may be installed in a state of being curved in a wave shape along the convex portion 32 and the valley portion 33. In this case, the photovoltaic power generation sheet 1 may be pressed against the valley portion 33 by fixing the attachment member 52 extending in the direction parallel to the water flow direction to the valley portion 33 in addition to the fixing of the convex portion 32 to the top portion 321. Further, the photovoltaic power generation sheet 1 may be fixed to the valley portion 33 instead of the top portion 321 of the convex portion 32 and pressed against the valley portion 33 by the attachment member 52. Therefore, the photovoltaic power generation sheet 1 is fixed to a portion between adjacent convex portions 32 by the attachment member 52 included as the fixing member 5.

The attachment member 52 may be formed in such a manner that the attachment member 52 extends in a direction orthogonal to the water flow direction, and may be formed in a substantially wavy shape along the shape of the uneven roof 31. In this case, the attachment member 52 presses the photovoltaic power generation sheet 1 from above over the entire length of the photovoltaic power generation sheet 1 across the convex portion 32 and the valley portion 33 of the exterior member 3. That is, the photovoltaic power generation sheet 1 is fixed to at least a portion between adjacent convex portions 32 by the attachment member 52 included as the fixing member 5.

### Summary of second embodiment

The second embodiment includes the following configuration.

Item 1. An installation structure for a photovoltaic power generation sheet including:
a photovoltaic power generation sheet including a power generator in which a plurality of power generation cells belt-shaped extending in one direction are arranged in a width direction; and
an attachment member that is long and attaches the photovoltaic power generation sheet to an installation surface by pressing the photovoltaic power generation sheet from above, wherein
the attachment member overlaps the power generator, and a longitudinal direction of the attachment member intersects a longitudinal direction of the power generation cells.

Item 2. The installation structure according to item 1, wherein
the installation surface is a roof surface having a gradient, and
the photovoltaic power generation sheet is disposed in such a manner that a longitudinal direction of the power generation cells intersects a water flow direction of the roof surface.

Item 3. The installation structure according to item 2, wherein
the roof surface is included in a uneven roof configured in such a manner that convex portions and concave portions extending in a water flow direction are alternately arranged in a lateral direction intersecting the water flow direction,
the photovoltaic power generation sheet is disposed in such a manner that a longitudinal direction of the power generation cells is along the lateral direction, and
the attachment member is disposed in such a manner that a longitudinal direction of the attachment member is along at least one of the convex portions, and the attachment member is attached to a top portion of the one convex portion.

Item 4. The installation structure according to any one of items 1 to 3, wherein
the installation surface is a roof surface having a gradient, and
the photovoltaic power generation sheet is disposed in such a manner that a longitudinal direction of the power generation cells is along a water flow direction of the roof surface.

Item 5. The installation structure according to item 4, wherein
the installation surface is a roof surface of a uneven roof having a gradient,
the uneven roof is configured in such a manner that convex portions and concave portions extending in a water flow direction are alternately arranged in a lateral direction intersecting the water flow direction, and
the attachment member is disposed in such a manner that a longitudinal direction of the attachment member is along the lateral direction, and is attached to the convex portions in such a manner of being across the plurality of the convex portions.

Item 6. The installation structure according to any one of items 1 to 5, wherein a longitudinal direction of the power generation cell is parallel to a longitudinal direction of the photovoltaic power generation sheet.

### Third embodiment

Conventionally, as a photovoltaic power generation module, there is a building material-integrated solar cell module in which a photovoltaic element is disposed between a back surface member and a surface member. The photovoltaic element is configured by sandwiching a semiconductor photoactive layer between a conductive flexible substrate and a transparent electrode layer. The semiconductor photoactive layer is configured by arranging a plurality of power generation cells extending in one direction in the width direction. In a conventional photovoltaic power generation module, when the photovoltaic power generation module is attached to a building, the longitudinal direction of the power generation cell is parallel to the direction in which water flows(water flow direction) on a surface.

In this case, when streaky dirt occurs on the surface of the photovoltaic power generation module, any one of the plurality of power generation cells arranged in the width direction is covered over the entire length in the longitudinal direction by the streaky dirt. There is a problem in this type of photovoltaic power generation sheet that, even when only one of the plurality of power generation cells is covered over the entire length in the longitudinal direction, the power generation efficiency is extremely decreased.

Furthermore, with the progress of technology in recent years, an increase in size of a photovoltaic power generation sheet has been studied because the photovoltaic power generation sheet is lightweight. Compared with a conventional rigid solar cell, a photovoltaic power generation sheet that is soft and flexible is likely to receive an external force due to wind or the like, and therefore it is necessary to further increase the number of fixing members. However, since the above-described streaky dirt is likely to accumulate near the fixing member and along the water flow direction, the power generation efficiency is more likely to decrease in the installation structure for the flexible photovoltaic power generation sheet 1.

Therefore, one object of the present embodiment is to suppress a decrease in power generation efficiency under a state where the photovoltaic power generation sheet 1 is installed. Hereinafter, an example of the installation structure 100 of the photovoltaic power generation sheet 1 according to the present embodiment will be described.

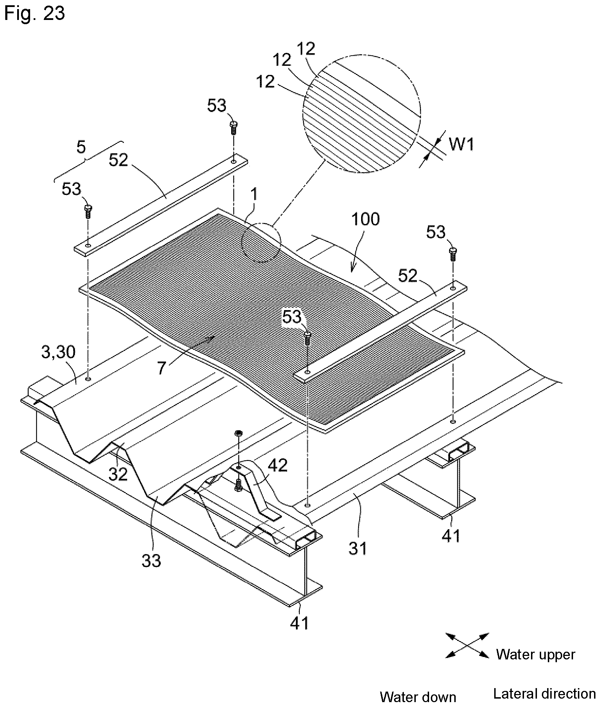

As illustrated in Fig. 23, the installation structure 100 of the photovoltaic power generation sheet 1 according to the present embodiment includes the photovoltaic power generation sheet 1 and an attachment member 52 for attaching the photovoltaic power generation sheet 1 to the installation surface 30. The photovoltaic power generation sheet 1 is a sheet material that generates power by receiving sunlight. The photovoltaic power generation sheet 1 includes one or a plurality of power generators 7. As illustrated in Fig. 23, the power generator 7 is monolithic in a state where belt-shaped power generation cells 12 extending in one direction are arranged side by side in the width direction of the power generation cells 12.

The photovoltaic power generation sheet 1 is disposed in such a manner that the longitudinal direction of the power generation cell 12 intersects the direction in which water flows on the installation surface. Therefore, in the installation structure 100 of the photovoltaic power generation sheet 1, in a case where streaky dirt (sometimes referred to as "thread dirt" or the like) occurs on the photovoltaic power generation sheet 1, only a part of the entire length of the belt-shaped power generation cell 12 is covered with the thread dirt, so that it is possible to reduce the decrease in power generation efficiency in each power generation cell 12. As a result, according to the installation structure 100 of the photovoltaic power generation sheet 1 according to the present embodiment, stable power generation efficiency can be obtained.

Since the configuration of the photovoltaic power generation sheet 1 of the present embodiment is substantially the same as that of the photovoltaic power generation sheet 1 of the second embodiment, redundant description will be omitted. In addition, each element of the third embodiment can be applied to the first embodiment and the second embodiment, or can be implemented only in the third embodiment without being affected by the first embodiment and the second embodiment.

### Power generator 7

In the power generator 7 of the present embodiment, the plurality of power generation cells 12 are monolithically arranged in the water flow direction. Each power generation cell 12 extends in a direction orthogonal to the water flow direction and is formed in a band shape. The longitudinal direction of the power generation cell 12 is parallel to the longitudinal direction of the photovoltaic power generation sheet 1. The configuration of each power generation cell 12 is the same as the configuration described in the second embodiment.

### Installation structure 100

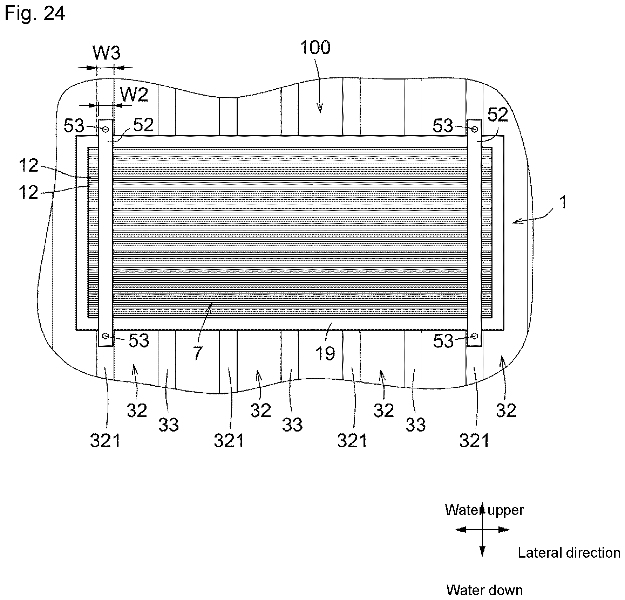

As in the first embodiment, the photovoltaic power generation sheet 1 may be attached to the installation surface 30 in a state of being deformed along the installation surface 30, or may be attached to the roof surface in a planar shape. Here, an example of being attached to the roof surface in a planar shape will be described. As illustrated in Fig. 23, the photovoltaic power generation sheet 1 is disposed across the top portions 321 of the plurality of convex portions 32, and is attached to the roof surface by the fixing member 5. The fixing member 5 includes a plurality of attachment members 52 and a fixture 53. In the present embodiment, as illustrated in Fig. 24, the photovoltaic power generation sheet 1 is disposed in such a manner that the longitudinal direction of the power generation cell 12 intersects the water flow direction.

The angle formed by the light receiving surface of the photovoltaic power generation sheet and the horizontal plane is preferably 1.5° or more, more preferably 5.0° or more, and still more preferably 15.0° or more. As a result, even when streaky dirt occurs, streaky dirt having a narrow width can be obtained. Since the photovoltaic power generation sheet according to the present embodiment has substantially the same thickness over the entire length, the "angle formed by the light receiving surface of the photovoltaic power generation sheet and the horizontal plane" is synonymous with the "angle formed by the installation surface and the horizontal plane".

Each of the attachment members 52 is formed in an elongated shape extending in one direction. The attachment member 52 is fixed to the installation surface 30, and the photovoltaic power generation sheet 1 can be attached to the installation surface 30 by pressing the photovoltaic power generation sheet 1 from above. Each attachment member 52 is disposed in such a manner that the longitudinal direction thereof intersects the longitudinal direction of the power generation cell 12. In the present embodiment, the longitudinal direction of each attachment member 52 is orthogonal to the longitudinal direction of the power generation cell 12, that is, parallel to the water flow direction. As illustrated in Fig. 24, the attachment members 52 overlap the power generator 7 in a state where the photovoltaic power generation sheet 1 is pressed against the roof surface. As described above, in the present embodiment, even when attachment members 52 overlap the power generator 7, all portions of each power generation cell 12 are not covered by the attachment members 52. As a result, when the power generator 7 having a monolithic structure having the belt-shaped power generation cell 12 is attached to the installation surface 30 by the attachment members 52, it is possible to simplify the installation structure while suppressing a decrease in power generation efficiency.

The plurality of attachment members 52 is disposed at intervals in the lateral direction. It is preferable that the plurality of attachment members 52 press the end portion of the photovoltaic power generation sheet 1 in the longitudinal direction. As a result, it is possible to suppress fluttering of the photovoltaic power generation sheet 1 due to the wind, to suppress a decrease in power generation efficiency, and to reduce breakage.

In a case where the photovoltaic power generation sheet 1 is curved along the plurality of convex portions 32, the attachment member 52 may be attached to the valley portion 33. As a result, the photovoltaic power generation sheet 1 can be fixed to a portion between adjacent convex portions 32 in a state where the photovoltaic power generation sheet 1 is curved along the plurality of convex portions 32 in the cross section.

### Effects of third embodiment

As described above, in the installation structure 100 of the photovoltaic power generation sheet 1 according to the present embodiment, the photovoltaic power generation sheet 1 is installed on the installation surface 30 in such a manner that the longitudinal direction of the power generation cell 12 intersects the water flow direction. Therefore, even when streaky dirt occurs on the light receiving surface of the photovoltaic power generation sheet 1, all the portions of each power generation cell 12 are not covered with the streaky dirt. Therefore, the photovoltaic power generation sheet 1 including the power generator 7 having the belt-shaped power generation cell 12 can be installed while suppressing a decrease in power generation efficiency. In particular, a solar cell using an organic compound such as a perovskite compound has a property that a decrease in power generation efficiency is limited even when a part of the power generation cell 12 in the longitudinal direction is covered, as compared with a solar cell using an inorganic compound. Therefore, according to the installation structure 100 of the photovoltaic power generation sheet 1 according to the present embodiment, it is possible to further suppress a decrease in power generation efficiency when the photovoltaic power generation sheet 1 is attached to the installation surface 30 having a gradient.

### Modifications

Hereinafter, modifications of the second embodiment will be listed. Modifications described below can be appropriately combined and applied.

### Seventeenth modification

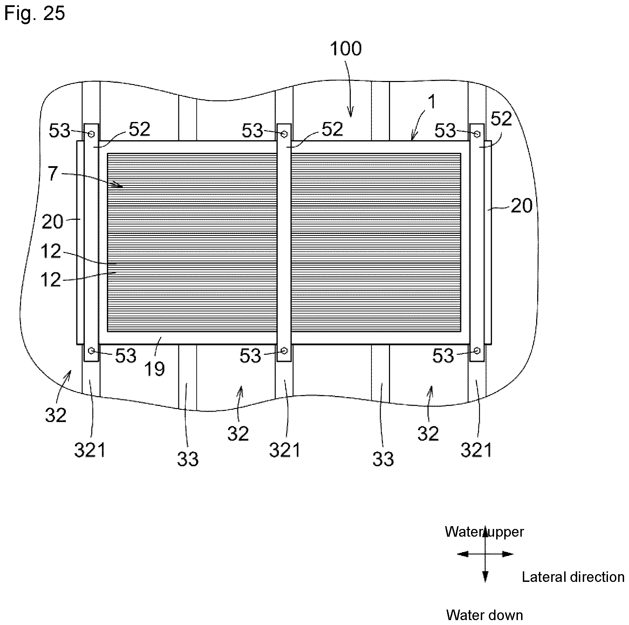

In the third embodiment, the photovoltaic power generation sheet 1 is attached by the two attachment members 52. However, as illustrated in Fig. 25, the photovoltaic power generation sheet 1 may be pressed at three or more positions of the two attachment members 52 that press both end portions of the photovoltaic power generation sheet 1 in the longitudinal direction and the attachment member therebetween. Further, the attachment member 52 may press a region 20 where the power generator 7 does not exist with respect to the installation surface 30 in the photovoltaic power generation sheet 1. Here, the attachment member 52 that presses the intermediate portion of the photovoltaic power generation sheet 1 in the longitudinal direction overlaps the power generator 7. However, it is preferable, in a case where the power generator 7 is divided into two or more sections, to press the region between adjacent power generators 7 with the attachment member 52.

### Eighteenth modification

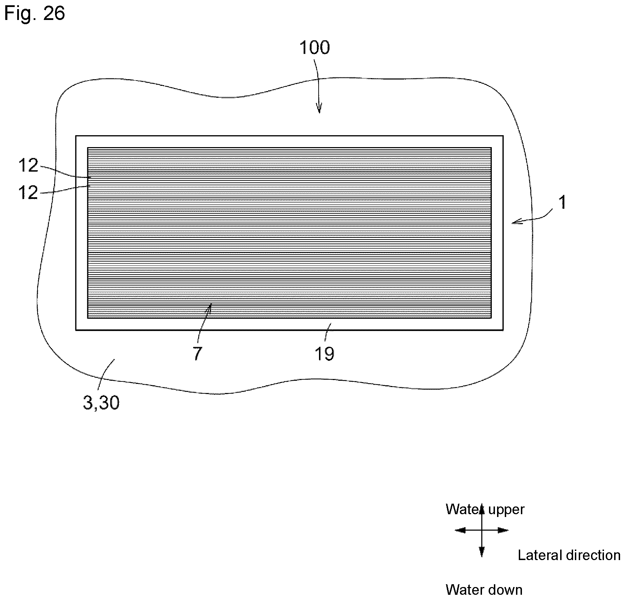

As illustrated in Fig. 26, the attachment member 52 may not be provided in attaching the photovoltaic power generation sheet 1. As the fixing member 5 for fixing the photovoltaic power generation sheet 1 to the installation surface 30, for example, a hook-and-loop fastener, a magnet, a double-sided tape, a bonder, a screw tool, a pin, a rivet, or the like may be used. For example, in a case of fixing with a magnet, one magnet may be fixed to the back surface of the photovoltaic power generation sheet 1 using a bonder, an adhesive, a double-sided tape, or the like, and the other magnet may be fixed to the installation surface 30 using a bonder, an adhesive, a double-sided tape, or the like. Note that in a case where the installation surface 30 has magnetism, a magnet that attracts the installation surface 30 only to the photovoltaic power generation sheet 1 may be fixed using a bonder, an adhesive, a double-sided tape, or the like. Specific examples of the magnet may include a neodymium magnet tape (NMS-3-200) manufactured by Sugatsune Kogyo Co., Ltd.

In the third embodiment, the roof surface is exemplified as the installation surface 30, and the installation surface 30 is not limited to the roof surface. When a bonder is used, it is preferable to select the bonder according to the location of the installation surface 30. For example, in an environment of an acidic atmosphere such as a water treatment plant, an acid-resistant bonder is preferably used. In addition, for example, in a coastal environment, a bonder having durability against salt damage is preferably used. In addition, for example, in a high-temperature and high-humidity environment, a bonder having moisture and heat resistance is preferably used.

### Nineteenth modification

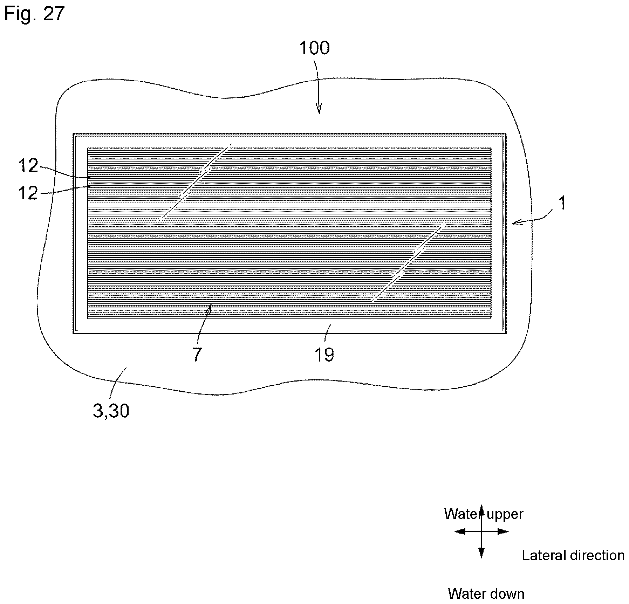

As illustrated in Fig. 27, as long as the longitudinal direction of the power generation cell 12 of the photovoltaic power generation sheet 1 intersects the water flow direction, the entire light receiving surface of the photovoltaic power generation sheet 1 may be attached in such a manner that the entire surface is covered with a case or the like having light-transmittance. In this case, the photovoltaic power generation sheet 1 is fixed to the installation surface 30 via the case. The material of the case and the like is not particularly limited, and examples thereof include hard resin, ceramic, glass, and the like, and may be soft resin. The outer surface of the light transmission plate covering the light receiving surface of the photovoltaic power generation sheet 1 in the case may be subjected to surface treatment/processing within a range not impairing the light-transmittance from the viewpoint of stain prevention and reflection prevention. In a case where the light transmission plate is detachably provided with respect to the photovoltaic power generation sheet 1, when significant dirt occurs on the light transmission plate, it is possible to more effectively suppress a decrease in efficiency due to dirt by replacing only the light transmission plate.

Further, in a roof member-integrated photovoltaic power generation module in which the roof member body and the photovoltaic power generation sheet 1 are integrated, the longitudinal direction of the power generation cell 12 may intersect the water flow direction.

### Other modifications

In the above embodiment, the photovoltaic power generation sheet 1 is installed to have a planar shape along a virtual plane including the top portion 321 of the convex portion 32 of the uneven roof 31. However, the photovoltaic power generation sheet 1 may also be installed in a state of being curved in a waveform along the convex portion 32 and the valley portion 33. In this case, sand, dirt, and the like are likely to accumulate on a portion corresponding to the valley portion 33, and only the portion corresponding to the valley portion 33 is likely to be covered with dirt and the like. However, according to the installation structure 100 of the photovoltaic power generation sheet 1 of this aspect, since the longitudinal direction of the power generation cells 12 intersects with the water flow direction, each power generation cell 12 is not entirely covered over the entire length, and a decrease in power generation efficiency can be reduced. When the photovoltaic power generation sheet 1 is attached in a state of being curved in a waveform along the valley portion 33 and the convex portions 32 of the uneven roof 31, the power generator 7 may not be provided at a position corresponding to the valley portion 33.

In a case of the photovoltaic power generation sheet 1 having the photoelectric conversion layer 152 containing a perovskite compound, the power generator 7 is not limited to a rectangular shape, and can be easily designed. By taking advantage of this characteristic, the shape of the photovoltaic power generation sheet 1 can be adapted to the shape of the installation surface 30. In the above embodiment, the photovoltaic power generation sheet 1 has a rectangular shape in plan view, and for example, in a case where the installation surface 30 has a fan shape in plan view, the photovoltaic power generation sheet 1 may also be formed in a fan shape in plan view. In this case, the longitudinal direction of the attachment member 52 may intersect the longitudinal direction of the power generation cell 12. The shape of the photovoltaic power generation sheet 1 is not limited to a fan shape, and examples thereof include a circular shape, an elliptical shape, and a polygonal shape.

The shortest distance between the end portion of the photovoltaic power generation sheet 1 and the power generator 7 is preferably 50 mm or less, more preferably 35 mm or less, and still more preferably 25 mm or less. In this manner, the power generation efficiency can be improved by making the area of the power generator 7 as large as possible. In addition, by setting the shortest distance between the end portion of the photovoltaic power generation sheet 1 and the power generator 7 to 5 mm or more, more preferably 10 mm or more, and still more preferably 15 mm or more, the water resistance when the photovoltaic power generation sheet 1 is used outdoors can be improved.

As described in another modification of the second embodiment, the rod-shaped core member may be attached to the end portion of the photovoltaic power generation sheet 1.

In the embodiment described above, the back sheet 11 of the photovoltaic power generation sheet 1 is directly fixed to the installation surface 30, and another sheet member may be interposed between the back sheet 11 and the installation surface 30. Examples of the sheet member include a synthetic resin sheet, a fiber-reinforced resin sheet, and an elastic sheet such as rubber. Thus, the photovoltaic power generation sheet 1 can be prevented from being displaced.

The sheet member is detachably attached to the installation surface 30. Thus, the photovoltaic power generation sheet 1 is detachably fixed to the installation surface 30. As a fixing structure between the sheet member and the installation surface 30, at least one selected from the group consisting of a hook-and-loop fastener, a magnet, a double-sided tape, a bonder, a flange member, a sandwiching member, a hanging member, and a frame member described above is used.

The installation surface 30 is not limited to the roof surface, and can be applied to, for example, a wall member (metal-based siding material, ceramic-based siding material, sandwich panel, and the like), a partition, a door member, a fence member, and the like. In this case, the vertical direction (direction from top to bottom) is the water flow direction.

In the first embodiment to the third embodiment (including all the modifications), as one aspect of the photovoltaic power generation sheet, the photovoltaic power generation sheet having a photoelectric conversion layer containing a perovskite compound has been described. However, as the attachment structure, a solar cell sheet being flexible can exhibit the same effect. In addition, the attachment structure may be a sheet (light energy conversion sheet) that converts light energy into another energy, in addition to a photovoltaic power generation sheet that can obtain a power generation effect by light. Examples of the light energy conversion sheet include, in addition to a photovoltaic power generation sheet, a light heating sheet (solar-powered thermoelectric conversion device) that converts light energy into thermal energy.

In the present disclosure, "parallel" refers to substantially "parallel", and includes not only a case where the straight line and the plane of the object do not intersect even when extended, but also a case where the straight line and the plane of the object intersect within a range of 10° when extended. "Orthogonal" refers to a straight line or a surface of an object intersecting within a range of 90° ± 10°, and includes not only a case of direct intersection but also a case of extended intersection.

### Summary of third embodiment

The third embodiment includes the following configuration.

Item 1. An installation structure for a photovoltaic power generation sheet in which a photovoltaic power generation sheet is attached to an installation surface intersecting a horizontal plane, wherein
the photovoltaic power generation sheet includes a power generator in which a plurality of belt-shaped power generation cells extending in one direction are arranged in a width direction, and
the photovoltaic power generation sheet is disposed with respect to the installation surface in such a manner that a longitudinal direction of each of the plurality of power generation cells intersects a water flow direction of the installation surface.

Item 2. The installation structure according to item 1, wherein
the installation surface is a roof surface of a uneven roof having a gradient,
the uneven roof is configured in such a manner that convex portions and concave portions extending in a water flow direction are alternately arranged in a lateral direction intersecting the water flow direction, and
a longitudinal direction of each of the power generation cells intersects a longitudinal direction of the convex portions and the concave portions.

Item 3. The installation structure according to item 1 or 2, wherein the power generator has a monolithic structure in which the plurality of power generation cells are monolithic.

Item 4. The installation structure according to any one of items 1 to 3, wherein a width of each of the power generation cells is 1 mm or more and 10 mm or less.

Item 5. The installation structure according to any one of items 1 to 4, wherein an angle formed by a light receiving surface of the photovoltaic power generation sheet and a horizontal plane is 15° or more.

### Description of Reference Numerals

1 Photovoltaic power generation sheet
17 Barrier sheet
2 Attachment portion
3 Exterior member
31 Fold plate member (uneven exterior member)
32 Convex portion
321 Top portion
33 Valley portion
5 Fixing member
6 Drain portion
7 Power generator
100 Installation structure

## Claims

1. An installation structure for a photovoltaic power generation sheet comprising:
an exterior member in which a plurality of convex portions extending in one direction are formed at intervals in a direction orthogonal to the one direction;
a photovoltaic power generation sheet that is disposed across the plurality of convex portions and is flexible; and
a fixing member that fixes the photovoltaic power generation sheet to a portion between the convex portions adjacent in a state where the photovoltaic power generation sheet is curved along the plurality of convex portions in a cross section.

2. The installation structure according to claim 1, wherein the photovoltaic power generation sheet has a flexural strength of 10 MPa or more and 200 MPa or less.

3. The installation structure according to claim 1 or claim 2, wherein the photovoltaic power generation sheet has a flexural modulus of 100 MPa or more and 10,000 MPa or less.

4. The installation structure according to any one of claim 1 to claim 3, wherein a portion of the photovoltaic power generation sheet fixed to the fixing member is positioned closer to a base side of the convex portion than a top surface of the convex portion.

5. The installation structure according to any one of claim 1 to claim 4, wherein the photovoltaic power generation sheet is not fixed to the plurality of convex portions.

6. The installation structure according to any one of claim 1 to claim 5, wherein the photovoltaic power generation sheet includes a power generator containing a perovskite compound.

7. The installation structure according to any one of claim 1 to claim 6, wherein the fixing member is attached to a portion other than the power generator in the photovoltaic power generation sheet.

8. The installation structure according to claim 7, wherein a minimum distance between the fixing member and the power generator positioned closest to the fixing member is 1.5 cm or more.

9. The installation structure according to any one of claims 1 to 8, wherein
the exterior member is a roof member,
the photovoltaic power generation sheet includes one barrier sheet covering a plurality of power generators, and
an intermediate portion of the one barrier sheet is fixed by the fixing member with respect to a portion between the convex portions adjacent, so that the intermediate portion constitutes a drain portion that is recessed and inclined downward the water down side.

10. A method for constructing a photovoltaic power generation sheet for attaching the photovoltaic power generation sheet being flexible to an exterior member where a plurality of convex portions extending in one direction is formed at intervals in a direction orthogonal to the one direction, the method comprising:
fixing the photovoltaic power generation sheet to a portion between the plurality of convex portions in a state where the photovoltaic power generation sheet is curved along the plurality of convex portions in a cross section.

11. A photovoltaic power generation sheet for an uneven exterior member, the photovoltaic power generation sheet being attached to an exterior member in which a plurality of convex portions extending in one direction is formed at intervals in a direction orthogonal to the one direction in a state where the photovoltaic power generation sheet is curved along the plurality of convex portions in a cross section, the photovoltaic power generation sheet comprising:
a plurality of power generators; and
an attachment portion provided between the plurality of power generators and fixed to a portion between the convex portions adjacent of the exterior member, wherein
the photovoltaic power generation sheet is flexible.
